**Europäisches Patentamt**

**European Patent Office**

**Office européen des brevets**

(19)

(11) **EP 1 511 209 A2**

(12) **EUROPEAN PATENT APPLICATION**

(43) Date of publication:
**02.03.2005 Bulletin 2005/09**

(51) Int Cl.$^7$: **H04L 1/00**

(21) Application number: **04019937.4**

(22) Date of filing: **23.08.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **23.08.2003 KR 2003058544**

(71) Applicant: **Samsung Electronics Co., Ltd.**
**Suwon-si, Gyeonggi-do (KR)**

(72) Inventors:
• **Sung, Hun-Geun**
**c/o Samsung Electronics Co., Ltd**
**Suwon-si, Gyeonggi-do (KR)**

• **Moon, Yong-Suk**
**c/o Samsung Electronics Co., Ltd**
**Suwon-si, Gyeonggi-do (KR)**
• **Lim, Young-Seok**
**c/o Samsung Electronics Co., Ltd**
**Suwon-si, Gyeonggi-do (KR)**
• **Choi, Gin-Kyu c/o Samsung Electronics Co., Ltd**
**Suwon-si, Gyeonggi-do (KR)**

(74) Representative: **Lang, Johannes, Dipl.-Ing. et al**
**Bardehle Pagenberg Dost Altenburg Geissler,**
**Postfach 86 06 20**
**81633 München (DE)**

(54) **Apparatus and method for transmitting/receiving data in a mobile comunication system**

(57) Disclosed are an apparatus and a method capable of preventing performance degradation during a channel decoding process. A bit interleaving is performed with respect to parity bits among coded bits output through a channel coding unit, thereby preventing a repetition period of the parity bits from matching a puncturing period for a rate matching. A bit de-interleaving is performed with respect to the parity bits during a channel decoding process, so that the parity bits have a repetition period identical to initial parity bits. Thus, the repetition period of the parity bits is not matched with the puncturing period for the rate matching, thereby preventing performance degradation during the channel decoding process.

FIG.24

**Description**

**BACKGROUND OF THE INVENTION**

Field of the Invention

The present invention relates to an apparatus and a method for transmitting/receiving data in a mobile communication system. More particularly, the present invention relates to an apparatus and a method for transmitting/receiving data in a mobile communication system while preventing performance degradation during a channel decoding process.

Description of the Related Art

Mobile communication systems have developed into high-speed and high-quality data packet communication systems capable of providing not only voice services, but also data services and multimedia services. In addition, standardization for high-speed and high-quality data packet services are being performed for the 3rd Generation Partnership Project (3GPP) and the 3rd Generation Partnership Project 2 (3GPP2), which are consortiums for providing standards for 3rd generation mobile communication systems. For instance, the 3GPP performs standardization for high-speed downlink packet access (hereinafter, simply referred to as "HSDPA") and the 3GPP3 performs standardization for First Evolution Data and Voice (IxEV-DV). Such standardization work is necessary to provide high-speed and high-quality wireless data packet transmission services at a speed above 2Mbps in the 3rd generation mobile communication systems. In a case of a 4th generation mobile communication system, which is a next generation mobile communication system of the 3rd generation mobile communication system, it is possible to provide high-speed and high-quality multimedia services at speeds above 2Mbps.

In a wireless communication system, a radio channel environment may exert a major influence on the high-speed and high-quality multimedia services. The radio channel environment may frequently vary depending on white noise, variation of signal power caused by fading, shadowing, a Doppler effect according to a movement and speed variation of a terminal, and interference caused by other users and multipath signals. Therefore, in order to provide high-speed and high-quality data packet services, it is necessary to provide an advanced technology having superior adaptive capability with respect to variation of the radio channel environment in addition to conventional technologies. A high-speed power control scheme employed in a conventional mobile communication system may improve adaptive capability of the mobile communication system with respect to variation of the radio channel environment. However, the 3GPP and the 3GPP2 performing standardization work for the high-speed data packet systems commonly suggest an adaptive modulation and coding scheme (AMCS) and a hybrid automatic repeat request (HARQ).

According to AMCS, a modulation scheme and a coding rate are varied according to variation of a channel environment of a downlink. Usually, the channel environment of the downlink is revealed by measuring a noise to signal ratio (NSR) at a terminal and transmitting NSR information to a base station through an uplink. Upon receiving the NSR information, the base station predicts the channel environment of the downlink based on the NSR information and determines the modulation scheme and the coding rate based on the predicted channel environment of the downlink.

Modulation schemes used for the high-speed packet data transmission systems include Quaternary Phase Shift Keying (QPSK), 8PSK, 16 Quadrature Amplitude Modulation (QAM) and 64QAM, and the coding rate used for the high-speed packet data transmission systems is 1/2 or 3/4. A mobile communication system employing the AMCS applies a higher modulation scheme of 16QAM or 640QAM and a higher coding rate of 3/4 to a terminal, which is positioned adjacent to a base station so that the terminal has a superior channel environment. However, the mobile communication system employing the AMCS applies a lower modulation scheme of QPSK or 8PSK and a lower coding rate of 1/2 to a terminal, which is positioned at a boundary area of cells so that the terminal has an inferior channel environment. The AMCS may reduce interference signals compared to a conventional high-speed power control scheme, thereby improving performance of the mobile communication system.

The HARQ is a link control scheme for requesting retransmission of a data packet when an error occurs in the data packet. Generally, the HARQ includes a chase combining (hereinafter, simply referred to as "CC") scheme, a full incremental redundancy (hereinafter, simply referred to as "FIR") scheme, and a partial incremental redundancy (hereinafter, simply referred to as "PIR") scheme.

According to the CC scheme, a packet identical to a packet previously transmitted at an initial stage is retransmitted. Thus, the retransmitted packet is combined with the previously transmitted packet at a receiving terminal. Thus, reliability of coded bits input into a decoder may be improved, so performance of the mobile communication system can be improved. At this time, since two same packets are combined with each other, an effect similar to a repetition coding effect may occur, so a performance gain of about 3dB on average may be achieved.

According to the FIR scheme, new parity bits are transmitted when retransmitting the packet so that performance of the decoder installed at the receiving terminal can be improved. That is, the coding is performed by using not only information obtained through an early stage transmission, but also new parity bits obtained through the retransmission of the packet, so that the coding rate can be reduced and performance of the decoder can be improved. As is generally known in the art, the performance gain based on a low coding rate is larger than a performance gain based on a repetition coding. Accordingly, when considering the performance gain only, the FIR scheme represents performance superior to that of the CC scheme.

The PIR scheme which is different from the FIR scheme retransmits the packet by using a combination of systematic bits and new parity bits. Accordingly, the retransmitted systematic bits are combined with previously transmitted systematic bits when coding the systematic bits so that the PIR scheme represents an effect similar to that of the CC scheme. In addition, since the PIR scheme uses the new parity bits, the PIR scheme represents an effect similar to that of the IR scheme. At this time, the coding rate of the PIR scheme is slightly higher than the coding rate of the FIR scheme, so the PIR scheme represents intermediate performance as compared with performance of the FIR scheme and the CC scheme.

The AMCS and HARQ may increase adaptive capability of the mobile communication system with respect to channel variation of the link in a separate manner. Thus, performance of the mobile communication system may be significantly improved if the mobile communication system employs a combination of the AMCS and HARQ.

As mentioned above, when receiving a signal transmitted from the mobile communication system using a terminal, it is difficult to receive a signal having no distortion and no noise, In particular, signal distortion and noise may increase when receiving the signal through a wireless network, instead of through a cable network.

Thus, there have been various attempts for reducing the signal distortion and noise. One of such attempts is an error control coding technology. Codes used for the error control coding technology are mainly divided into memoryless codes and memory codes. The memoryless code includes a linear block code and the memory code includes a convolutional code and a turbo code. The above-mentioned codes include a channel encoder, and an output of the channel encoder is divided into systematic bits and parity bits according to an error control coding technique thereof. The turbo code is a code used for the error control coding technique separately outputting the systematic bits and the parity bits. A channel coding technique using the turbo code may represent performance approximately approaching the Shannon limit in view of a bit error rate (BER) at a low SNR. For this reason, the turbo code is employed as a standard code for a next-generation mobile communication system requiring high reliability for transmitting high-speed multimedia data.

A "systematic bit" signifies a signal to be transmitted and a "parity bit" is a signal added during the channel coding process. In addition, the parity bit is used for correcting an error during a decoding process. However, it is difficult to correct a burst error created in the systematic bit or the parity bit even in a case of an error control coded signal. The burst error is frequently created when a signal passes through a fading channel. In order to prevent the burst error, an interleaving technique has been suggested. In the interleaving technique, damage occurring during a data transmission cannot be concentrated in one spot, but is distributed to various spots, thereby preventing a burst error.

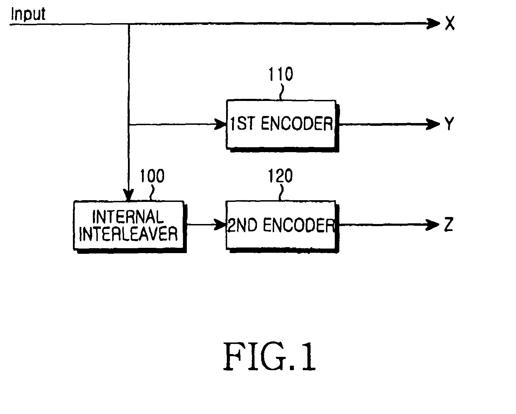

FIG. 1 is a view showing a turbo coder using a turbo code for error control coding. The turbo coder includes two coders 110 and 120 and one internal interleaver 100.

Referring to FIG. 1, an input signal is directly output as a systematic bit X and input into the first coder 110. The signal input into the first coder 110 is subject to a predetermined coding process and is output as a first parity bit Y. In addition, the input signal is input into the internal interleaver 100. The input signal is interleaved by means of the internal interleaver 100 so that an interleaving signal is input into the second coder 120. The second coder 120 outputs a second parity bit Z by coding the interleaving signal.

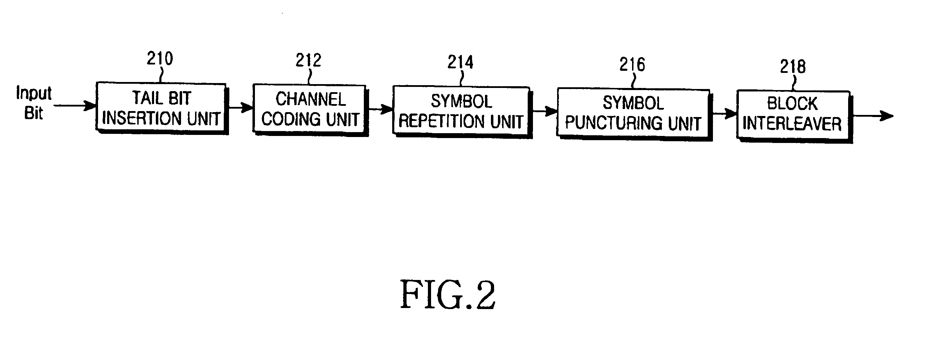

FIG. 2 is a diagram illustrating a structure for creating a high-speed transport channel for supporting IxEX-DV of the 3GPP2.

Referring to FIG. 2, the N-number of transport blocks is introduced into a tail bit insertion unit 210 so that tail bits are added to the corresponding transport blocks. The N-number of transport blocks having the tail bits is input into a channel coding unit 212. Thus, bits forming the N-number of transport blocks are coded by means of the channel coding unit 212 and are output as coded bits. The channel coding unit 212 represents at least one coding rate for coding the N-number of transport blocks, such as 1/2 or 3/4. The channel coding unit 212 may obtain a desired coding rate by performing code symbol puncturing or code symbol repetition using a 1/6 mother code or a 1/5 mother code. It is necessary for the channel coding unit 212 to determine a coding rate by controlling the code symbol puncturing or code symbol repetition if the channel coding unit 212 represents a plurality of coding rates.

The coded bit processing requires a symbol repetition unit 214 for performing a rate matching and a symbol puncturing unit 216 for performing symbol bit puncturing. The rate matching may be achieved by performing repetition and puncturing with respect to coded bits when there is a transport channel multiplexing or the coded bits do not match the number of symbols transmitted through a wireless network. The symbol repetition unit 214 repeatedly outputs the coded bits if the number of bits is smaller than the number of bits to be transmitted through a physical channel. The symbol puncturing unit 216 punctures predetermined coded bits corresponding to a predetermined puncturing pattern and outputs remaining coded bits if the number of bits is larger than the number of bits to be transmitted through the physical channel. Then, rate matched coded bits are input into a block interleaver 218 and output through the block interleaver 218 after being interleaved by means of the block interleaver 218. Such an interleaving operation may minimize data loss during data transmission.

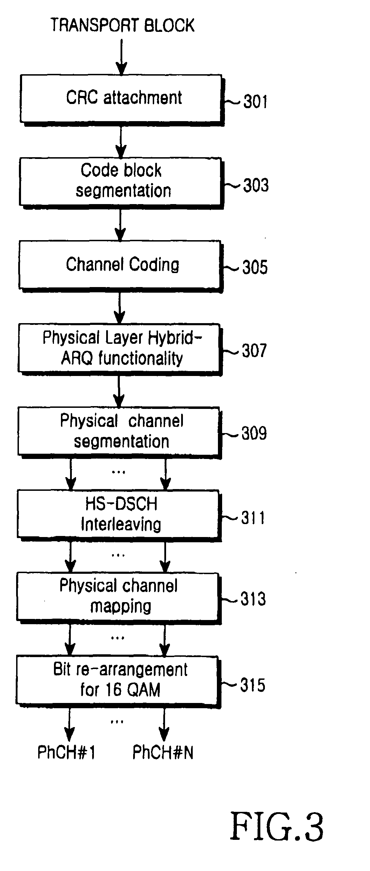

FIG. 3 is a block diagram illustrating a procedure for creating a high-speed transport channel for supporting HSDPA for the 3GPP.

Referring to FIG. 3, a block 301 creates a CRC with respect to a transport block being input and attaches the CRC to the transport block. The transport block having the CRC is segmented into code blocks by means of a block 303 equal to a size of an internal interleaver forming a channel coding unit. Then, a channel coding process is performed with respect to the code blocks by means of a block 305. In addition, a block 307 performs a process, such as AMC or IR (incremental redundancy), with respect to a coded bit array output from the block 305 for supporting the HARQ. That is, the coded bits for the HARQ are selectively output from the block 307. The coded bit array output from the block 307 is segmented into a plurality of coded bit arrays by means of a block 309 such that the coded bit arrays can be transmitted through a physical channel. The coded bit arrays are transmitted to a block 311. Each of the coded bit arrays is interleaved by means of the block 311 and the interleaved coded bit arrays are mapped with corresponding physical channels by means of a channel 313. The coded bits mapped with the physical channels are rearranged by means of a block 315 for a modulation scheme of 16 QAM and finally output through the corresponding physical channels.

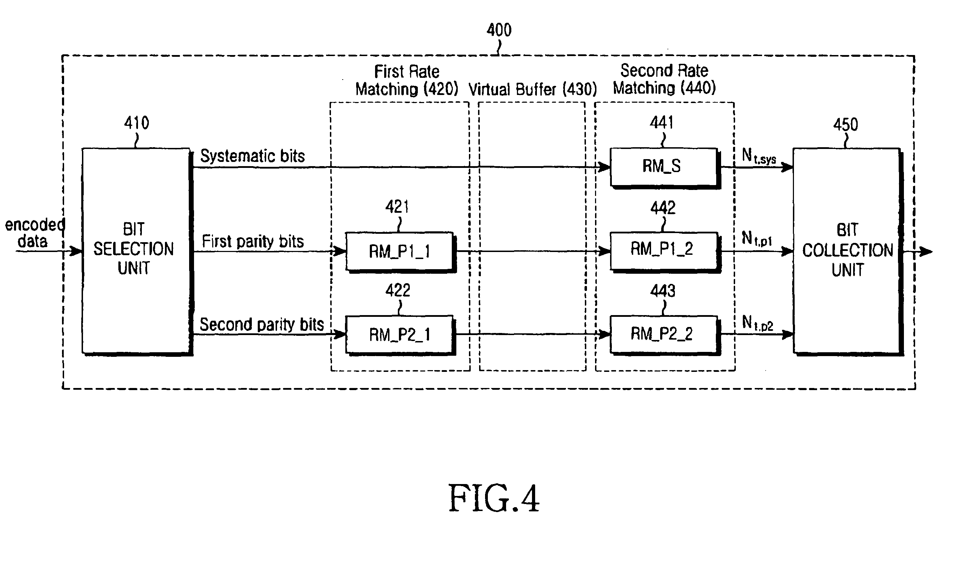

FIG. 4 is a block diagram illustrating a structure of a rate matching unit 400 for supporting the conventional AMC and HARQ.

Referring to FIG. 4, coded bits, which have been coded with a predetermined coding rate, are input into a bit selection unit 410 of the rate matching unit 400. The bit selection unit 410 selects systematic bits, first parity bits and second parity bits from the coded bits. In addition, the bit selection unit 410 outputs a systematic bit array consisting of the systematic bits, a first parity bit array consisting of the first parity bits and a second parity array consisting of the second parity bits to a first rate matching unit 420. The first rate matching unit 420 includes two blocks 421 and 422, which do not perform the rate matching with respect to the systematic bit array, but perform the rate matching with respect to the first and second parity bit arrays, respectively. The first block 421 performs the rate matching with respect to the first parity bit array and the second block 422 performs the rate matching with respect to the second parity bit array. According to the rate matching performed by means of the first rate matching unit 420, output bits may match a size of virtual buffer 430 used for each user. The virtual buffer 430 stores coded bits for retransmission. The second rate matching section 440 includes three blocks 441, 442 and 443 corresponding to the systematic bit array, the first parity bit array and the second parity bit array. Each of three blocks 441, 442 and 443 performs the rate matching for determining coded bits to be transmitted through the physical channel from among coded bits stored in the virtual buffer 430. Thus, the number of coded bits output from the second rate matching unit 440 equals the number of coded bits transmitted through the physical channel. In addition, the second rate matching section 440 changes a pattern of the coded bits being output according to a transmission mode, such as an initial transmission mode or a retransmission mode, in order to support the HARQ. A bit collection unit 450 is provided to rearrange three bit arrays output from the second rate matching unit 440 into one bit array.

Due to such an operation of the rate matching unit 400, the number of coded bits input into the rate matching unit 400 does not equal the number of coded bits output from the rate matching unit 440. That is, the coding rate based according to the output of the rate matching unit 400 is different from the coding rate used in a channel coding unit. The relationship between the number of input systematic bits and the number of output coded bits output from the rate matching unit may be represented by an effective coding rate. The effective coding rate is defined as represented in Equation 1.

Equation 1

Effective coding rate = the number of input systematic bits/the number of

output coded bits output from a rate matching unit

Usually, in a mobile communication system providing HSDPA services, the effective coding rate may change in proportion to the number of punctured bits. That is, when the number of punctured bits increases, the effective coding rate and a block error rate (BLER) are also increased. In other words, more transmission power must be supplied from the base station as the number of punctured bits increases.

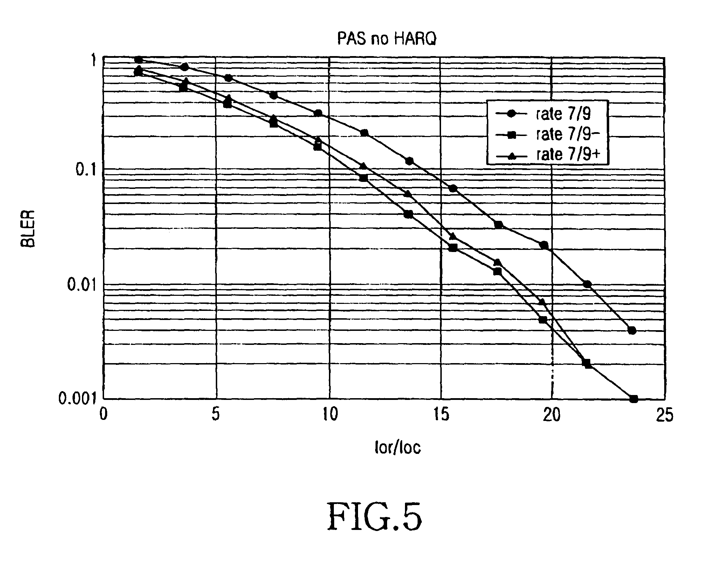

FIG. 5 is a graph illustrating desired transmission power levels of the base station corresponding to variations of the effective coding rate when the BLER is fixedly set to about 10%. As shown in FIG. 5, a first curved line positioned adjacent to a zero point of the graph represents the effective coding rate of 0.75 (7/9-), a second curved line positioned adjacent to the first curved line represents the effective coding rate of 0.75 (7/9+), and a third curved line positioned at an outermost part of the graph represents the effective coding rate of 0.77 (7/9). The graph shown in FIG 5 represents an exceptional case obviating from a common expectation. In particular, the result obtained by comparing the second curved line representing the effective coding rate of 0.8 with the curved line representing the effective coding rate of 0.77 is greatly different from the common expectation.

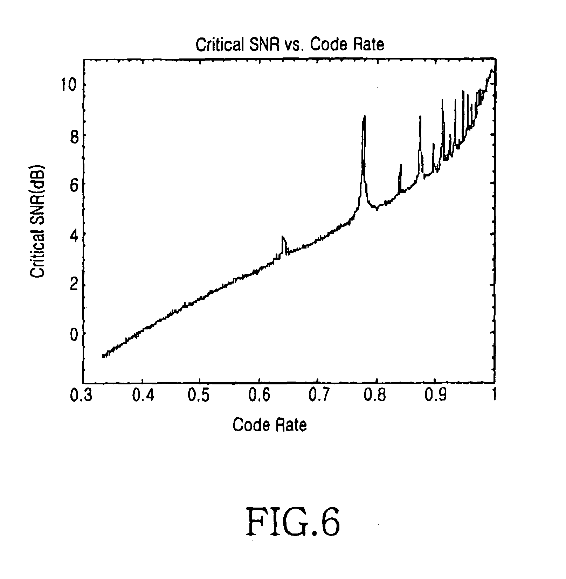

FIG. 6 is a graph illustrating variations of an SNR caused by variations of the effective coding rate in the mobile communication system. Similar to FIG. 5, FIG. 6 shows the desired NSR corresponding to variations of the effective coding rate at a fixed BLER (about 10%). The result obtained from FIG. 6 is also different from the common expectation. In general, in a mobile communication system employing a fixed effective coding rate, the puncturing algorithm for the coded bits is preferably performed by uniformly diffusing the coded bits. However, in a mobile communication system employing a variable effective coding rate, the creation period of the parity bits according to the constraints number of a channel encoder equals a period of the parity bits, which are not punctured after the rate matching at a specific coding rate, so that performance of the encoder/decoder may be deteriorated.

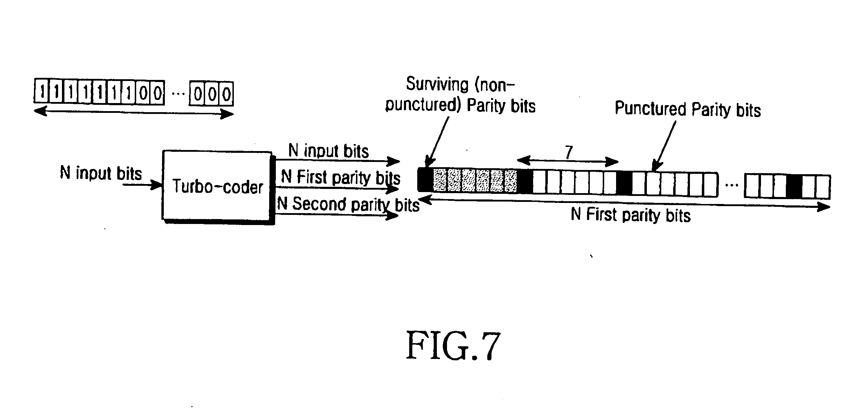

FIG. 7 shows a periodicity of parity bits output from the channel encoder (turbo coder). Such a periodicity of the parity bits may vary depending on a size of a memory of the channel encoder. That is, the periodicity of the parity bits is determined based on the size of the memory.

Typically, the puncturing operation is performed within a predetermined interval. That is, when the parity bits passing through the channel encoder are punctured and output, a predetermined periodicity may be found between a period of the parity bits output from the channel encoder and the puncturing period. If the channel encoder shown in FIG. 7 is a convolutional encoder having a coding rate of 1/3, the output period of the channel encoder is 7. Accordingly, the first and second parity bits output from the channel encoder have the periodicity of 7, respectively.

The rate matching unit compares the number of bits to be transmitted through the physical channel and the number of bits from the channel encoder and performs the puncturing operation based on the above comparison. At this time, if the puncturing operation is performed with a period of 7, which is identical to an output period of the channel encoder, the coded bits aligned in the same position are punctured and other coded bits aligned in the same position may remain, thereby deteriorating performance of the channel encoder/decoder.

## SUMMARY OF THE INVENTION

Accordingly, the present invention has been made to solve the above-mentioned problems occurring in the prior art, and an object of the present invention is to provide a mobile communication system capable of preventing performance degradation during channel decoding.

Another object of the present invention is to provide an apparatus and a method capable of preventing performance degradation of a channel decoder during channel decoding by performing a bit interleaving with respect to coded bits.

Still another object of the present invention is to provide an apparatus and a method for performing a bit de-interleaving with respect to received coded bits in order to prevent performance degradation.

Still another object of the present invention is to provide an apparatus and a method for performing a bit interleaving with respect to a parity bit array in such a manner that the parity bit array has no repetition period identical to a puncturing period for a rate matching.

Still another object of the present invention is to provide an apparatus and a method for performing a bit interleaving with respect to a parity bit array having a repetition period identical to a puncturing period for a rate matching.

Still another object of the present invention is to provide an apparatus and a method for performing a bit de-interleaving with respect to a parity bit array having a repetition period identical to a puncturing period for a rate matching.

Still another object of the present invention is to provide an apparatus and a method for simultaneously performing a bit interleaving and a block interleaving with respect to a systematic bit array and a parity bit array output from a channel encoder.

Still another object of the present invention is to provide an apparatus and a method for preventing parity bits output from a channel encoder from representing a periodicity at a specific puncturing rate, and aligning non-punctured parity bits in such a manner that non-punctured parity bits do not cause performance degradation of a receiver.

In order to accomplish these objects, according to a first aspect of the present invention, there is provided a transmitter for a mobile communication system including a channel coding unit for performing a channel coding with respect to at least one bit array being input into the channel coding unit in order to output at least one systematic bit array and a plurality of parity bit arrays. The transmitter comprises at least one bit interleaver for receiving the parity bit arrays and performing bit interleaving with respect to the parity bit arrays in such a manner that a repetition period of parity bits in each parity bit array does not match with a puncturing pattern for a rate matching; and a rate matching unit receiving at least one systematic bit array and the parity bit arrays, which have undergone the bit interleaving, in order to perform the rate matching with respect to at least one systematic bit array and the parity bit arrays, wherein a number of bits forming the systematic bit array and the parity bit arrays output through the rate matching is identical to a number of bits to be transmitted through at least one assigned physical channel.

In order to accomplish these objects, according to a second aspect of the present invention, there is provided a method of receiving data in a mobile communication system including a channel coding unit for performing a channel coding with respect to at least one bit array being input into the channel coding unit in order to output at least one systematic bit array and a plurality of parity bit arrays. The method comprising receiving the parity bit arrays and performing bit interleaving with respect to the parity bit arrays in such a manner that a repetition period of parity bits in each parity bit array does not match with a puncturing pattern for a rate matching; and receiving at least one systematic bit array and the parity bit arrays, which have undergone the bit interleaving, in order to perform the rate matching with respect to at least one systematic bit array and the parity bit arrays, wherein a number of bits forming the systematic bit array and the parity bit arrays output through the rate matching is identical to a number of bits to be transmitted through at least one assigned physical channel.

In order to accomplish these objects, according to a third aspect of the present invention, there is provided a transmitter for a mobile communication system including a channel coding unit for performing a channel coding with respect to at least one bit array being input into the channel coding unit in order to output at least one systematic bit array and a plurality of parity bit arrays. The transmitter comprises at least one bit interleaver for receiving the parity bit arrays and performing bit interleaving with respect to the parity bit arrays in such a manner that a repetition period of parity bits in each parity bit array does not match a puncturing pattern for a rate matching; a rate matching unit receiving at least one systematic bit array and first parity bit arrays or second parity bit arrays, which have undergone the bit interleaving, in order to perform the rate matching with respect to at least one systematic bit array and the first parity bit arrays or the second parity bit arrays in such a manner that a predetermined number of bits to be transmitted through at least one assigned physical channel is output from the rate matching unit: and a switch unit for switching the parity bit arrays to at least one bit interleaver when a specific coding rate is used for a channel coding and switching the parity bit arrays to the rate matching unit when coding rates different from the specific coding rate are used for the channel coding, wherein parity bit arrays having a repetition period matching with a puncturing pattern for the rate matching are output at the specific coding rate.

In order to accomplish these objects, according to a fourth aspect of the present invention, there is provided a method of transmitting data in a mobile communication system including a channel coding unit for performing a channel coding with respect to at least one bit array being input into the channel coding unit in order to output at least one systematic bit array and a plurality of parity bit arrays. The method comprising receiving the parity bit arrays when a specific coding rate is used for a channel coding and performing bit interleaving with respect to the parity bit arrays in such a manner that a repetition period of parity bits in each parity bit array does not match a puncturing pattern for a rate matching; receiving at least one systematic bit array and parity bit arrays, which have undergone the bit interleaving, in order to perform the rate matching with respect to at least one systematic bit array and the parity bit arrays in such a manner that a predetermined number of bits to be transmitted through at least one assigned physical channel is output; and receiving at least one systematic bit array and parity bit arrays when coding rates different from the specific coding rate are used for the channel coding in order to perform the rate matching with respect to at least one systematic bit array and the parity bit arrays in such a manner that a predetermined number of bits to be transmitted through at least one assigned physical channel is output, wherein parity bit arrays having a repetition period matching a puncturing pattern for the rate matching are output at the specific coding rate.

In order to accomplish these objects, according to a fifth aspect of the present invention, there is provided a transmitter for a mobile communication system. The transmitter comprises a channel coding unit for performing a channel coding with respect to at least one bit array according to a predetermined coding rate in order to output coded bit arrays: a bit selection unit for selecting at least one systematic bit array and a plurality of parity bit arrays from the coded bit arrays; a control unit for outputting a switch control signal depending on a coding rate being used; a switch unit for switching the parity bit arrays based on the switch control signal; at least one bit interleaver for receiving the parity bit arrays from the switch section when a specific coding rate is used as the predetermined coding rate and performing bit interleaving with respect to the parity bit arrays in such a manner that a repetition period of parity bits in each parity bit array does not match a puncturing pattern for a rate matching; and a rate matching unit for receiving first parity bit arrays, which have undergone the bit interleaving or second parity bit arrays transmitted from the switch unit when coding rates different from the specific coding rate are used together with at least one systematic bit array in order to perform the rate matching with respect to at least one systematic bit array and the first parity bit arrays or the second parity bit arrays in such a manner that a predetermined number of bits to be transmitted through at least one assigned physical channel is output from the rate matching unit, wherein parity bit arrays having a repetition period matching a puncturing pattern for the rate matching are output at the specific coding rate.

In order to accomplish these objects, according to a sixth aspect of the present invention, there is provided a method of transmitting data in a mobile communication system. The method comprising performing a channel coding with respect to at least one bit array according to a predetermined coding rate in order to output coded bit arrays; selecting at least one systematic bit array and a plurality of parity bit arrays from the coded bit arrays; receiving the parity bit arrays when a specific coding rate is used as the predetermined coding rate and performing bit interleaving with respect to the parity bit arrays in such a manner that a repetition period of parity bits in each parity bit array does not match a puncturing pattern for a rate matching; receiving the parity bit arrays, which have undergone the bit interleaving, and at least one systematic bit array in order to perform the rate matching with respect to the parity bit arrays and at least one systematic bit array in such a manner that a predetermined number of bits to be transmitted through at least one assigned physical channel is output; and receiving the parity bit arrays and at least one systematic bit array when coding rates different from the specific coding rate are used as the predetermined coding rate and performing the rate matching with respect to the parity bit arrays and at least one systematic bit array in such a manner that a predetermined number of bits to be transmitted through at least one assigned physical channel is output, wherein parity bit arrays having a repetition period matching a puncturing pattern for the rate matching are output at the specific coding rate.

In order to accomplish these objects, according to a seventh aspect of the present invention, there is provided a receiver for receiving coded bit arrays including at least one systematic bit array and a plurality of parity bit arrays in a mobile communication system. The receiver comprises a de-rate matching unit for receiving the parity bit arrays and at least one systematic bit array in order to perform a de-rate matching with respect to the parity bit arrays and at least one systematic bit array; and at least one bit de-interleaver for receiving the parity bit arrays, which have undergone the de-rate matching, and performing a bit de-interleaving with respect to the parity bit arrays in such a manner that parity bits in each parity bit array have a repetition period identical to a repetition period of parity bits which do not undergo the bit interleaving in the transmitter.

In order to accomplish these objects, according to an eighth aspect of the present invention, there is provided a method for receiving coded bit arrays including at least one systematic bit array and a plurality of parity bit arrays in a mobile communication system. The method comprising receiving the parity bit arrays and at least one systematic bit array in order to perform a de-rate matching with respect to the parity bit arrays and at least one systematic bit array; and receiving the parity bit arrays, which have undergone the de-rate matching, and performing a bit de-interleaving with respect to the parity bit arrays in such a manner that parity bits in each parity bit array have a repetition period identical to a repetition period of parity bits which do not undergo the bit interleaving in a transmitter.

In order to accomplish these objects, according to an ninth aspect of the present invention, there is provided a receiver for receiving coded bit arrays including at least one systematic bit array and a plurality of parity bit arrays in a mobile communication system. The receiver comprises a de-rate matching unit for receiving the parity bit arrays and at least one systematic bit array in order to perform a de-rate matching with respect to the parity bit arrays and at least one systematic bit array; at least one bit de-interleaver for receiving the parity bit arrays, which have undergone the de-rate matching, and performing a bit de-interleaving with respect to the parity bit arrays in such a manner that parity bits in each parity bit array have a repetition period identical to a repetition period of parity bits which do not undergo the bit interleaving in a transmitter; a bit collection unit for receiving at least one bit array and first parity bit arrays or second parity bit arrays, which have undergone the bit de-interleaving, in order to output one coded bit array; and a switch unit for switching the parity bit arrays to at least one bit de-interleaver when a specific coding rate is used for a channel coding and switching the parity bit arrays to the bit collection unit when coding rates different from the specific coding rate are used for the channel coding, wherein parity bit arrays having a repetition period matching with a puncturing pattern for the rate matching are output at the specific coding rate.

In order to accomplish these objects, according to a tenth aspect of the present invention, there is provided a method for receiving coded bit arrays including at least one systematic bit array and a plurality of parity bit arrays in a mobile communication system. The method comprising receiving the parity bit arrays and at least one systematic bit array in order to perform a de-rate matching with respect to the parity bit arrays and at least one systematic bit array; performing a bit de-interleaving with respect to the parity bit arrays when a specific coding rate is used for a channel coding in such a manner that parity bits in each parity bit array have a repetition period identical to a repetition period of parity bits which do not undergo the bit interleaving in a transmitter; receiving at least one bit array and the parity bit arrays, which have undergone the bit de-interleaving, in order to output one coded bit array; and receiving at least one bit array and the parity bit arrays in order to output one coded bit array when coding rates different from the specific coding rate are used for the channel coding, Wherein parity bit arrays having a repetition period matching a puncturing pattern for the rate matching are output at the specific coding rate.

## BRIEF DESCRIPTION OF THE DRAWINGS

The above and other objects, features and advantages of the present invention will be more apparent from the following detailed description taken in conjunction with the accompanying drawings, in which:

FIG. 1 is a block diagram illustrating a conventional turbo coder;
FIG. 2 is a block diagram illustrating a structure for creating a high-speed transport channel in a conventional synchronous mobile communication system;
FIG. 3 is a block diagram illustrating a procedure for creating a high-speed transport channel in a conventional asynchronous mobile communication system;
FIG. 4 is a block diagram illustrating a structure of a conventional rate matching unit;
FIG. 5 is a graph illustrating transmission power levels of a base station corresponding to variations of an effective coding rate in a mobile communication system;
FIG. 6 is a graph illustrating a noise to signal ratio (NSR) corresponding to variations of an effective coding rate in a mobile communication system;
FIG. 7 is a diagram illustrating a period of parity bits output from a conventional channel encoder, illustrating that the period of parity bits equals a puncturing period;
FIG. 8 is a block diagram illustrating a transmitter according to an embodiment of the present invention;
FIG. 9 is a block diagram illustrating a transmitter of a synchronous mobile communication system according to a first embodiment of the present invention;
FIG. 10 is a block diagram illustrating a transmitter of an asynchronous mobile communication system according to a first embodiment of the present invention;
FIG. 11 is a block diagram illustrating a bit interleaver for parity bits according to a first embodiment of the present invention;
FIGS. 12 to 15 are block diagrams illustrating various bit interleavers according to a first embodiment of the present invention;
FIG. 16 is a flowchart illustrating an operation of a transmitter selectively performing a bit interleaving based on coding rates according to a first embodiment of the present invention;
FIG. 17 is a flowchart illustrating an operation of a transmitter selectively performing a bit interleaving regardless of coding rates according to a first embodiment of the present invention;
FIG. 18 is a block diagram illustrating a receiver according to one embodiment of the present invention;
FIG. 19 is a block diagram illustrating a receiver of an asynchronous mobile communication system according to a first embodiment of the present invention;
FIGS. 20 and 21 are block diagrams illustrating various bit de-interleavers according to a first embodiment of the present invention;
FIG. 22 is a flowchart illustrating an operation of a receiver according to a first embodiment of the present invention in which a bit de-interleaving is selectively performed at a specific coding rates;
FIG. 23 is a flowchart illustrating an operation of a receiver according to a first embodiment of the present invention in which a bit de-interleaving is performed regardless of coding rates;
FIG. 24 is a diagram illustrating an example of a bit interleaving and a bit de-interleaving according to a first embodiment of the present invention when a bit interleaver or a bit de-interleaver is provided for each parity bit array;
FIG. 25 is a diagram illustrating an example of a bit interleaving and a bit de-interleaving according to one embodiment of the present invention when one bit interleaver or one bit de-interleaver is provided for parity bit arrays;
FIG 26 is a block diagram illustrating a transmitter of a synchronous mobile communication system according to a second embodiment of the present invention;
FIG. 27 is a block diagram illustrating a transmitter of an asynchronous mobile communication system according to a second embodiment of the present invention;
FIG. 28 is a block diagram illustrating a bit interleaver provided for each bit array (systematic bit array and parity bit array) according to a second embodiment of the present invention; and
FIGS. 29 and 30 are graphs illustrating test results obtained by using a bit interleaver according to one embodiment of the present invention.

Throughout the drawings, it should be noted that the same or similar elements are denoted by like reference numerals.

## DETAILED DESCRIPTION OF THE PREFERRED EMBODIMENTS

Hereinafter, embodiments of the present invention will now be described with reference to the accompanying drawings. In the following detailed description, representative embodiments of the present invention will be described. In addition, a detailed description of known functions and configurations incorporated herein will be omitted for conciseness.

The embodiments of the present invention provide a method of carrying out a bit interleaving with respect to coded bits in such a manner that a period of a parity bit array output from a channel encoder does not match a puncturing period of the coded bits. According to a first embodiment of the present invention, a bit interleaving is separately performed with respect to a rate matched coded bit array in addition to a block interleaving. According to a second embodiment of the present invention, an interleaver capable of simultaneously performing a bit interleaving and a block interleaving with respect to a rate matched coded bit array is provided. Thus, the bit interleaving and the block interleaving are simultaneously performed by means of the interleaver. In addition, although the present invention discloses a channel encoder performing a turbo coding algorithm, an encoder performing a channel coding algorithm by using parity bits and systematic bits, such as a low density parity check coding algorithm (LDPC), can be used for the present invention.

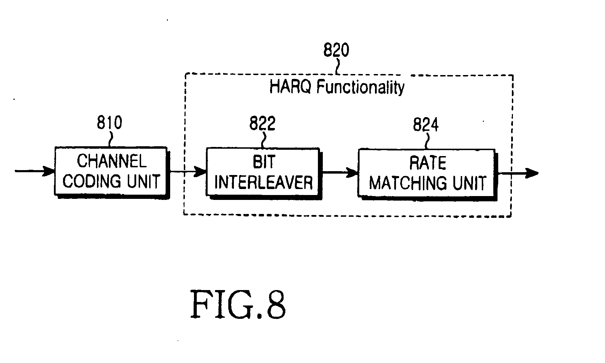

FIG. 8 is a block view showing a transmitter according to one embodiment of the present invention. As shown in FIG. 8, a bit interleaver 822 is added to a functional block 820 connected to a channel coding unit 810 in order to perform the HARQ. Thus, a coded bit array is provided to the bit interleaver 822 from the channel coding unit 810. The bit interleaver 822 performs an interleaving with respect to each coded bit of the coded bit array. The bit interleaver 822 performs bit interleaving with respect to a predetermined unit of the coded bit array. Then, the coded bit array, which has been interleaved by means of the bit interleaver 822, is transmitted to a rate matching unit 824. Upon receiving the coded bit array, the rate matching unit 824 performs the rate matching with respect to the coded bits of the coded bit array in such a manner that the coded bits can be transmitted through a physical channel.

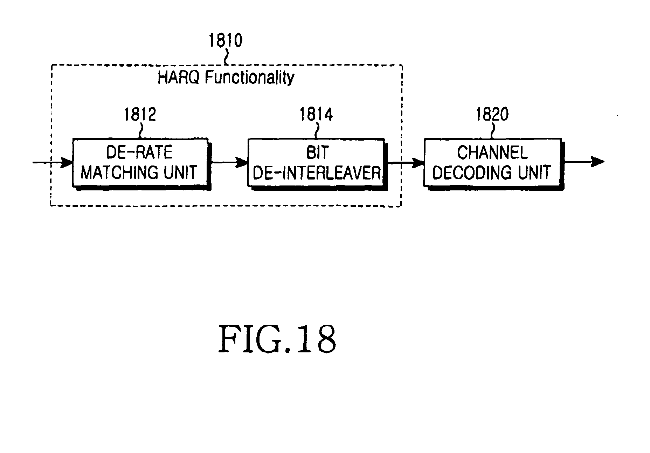

FIG. 18 is a block diagram illustrating a receiver according to one embodiment of the present invention. As shown in FIG. 18, a bit de-interleaver 1814 is added to a functional block 1810 performing the hybrid automatic repeat request (HARQ). Thus, a coded bit array transmitted through the physical channel is provided to a de-rate matching unit 1812 so that the coded bit array is rearranged in the form of an initial coded bit array which does not undergo the rate matching process in the transmitter. The rearranged coded bit array is transferred to the bit de-interleaver 1814 which is added to the functional block 1810. The bit de-interleaver 1814 performs de-interleaving with respect to each coded bit of the coded bit array. The bit de-interleaver 1814 performs a bit de-interleaving with respect to a predetermined unit of the coded bit array. Then, the coded bit array, which has been de-interleaved by means of the bit de-interleaver 1814, is transmitted to a channel decoding unit 1820 so that systematic bits are output.

Embodiment 1

Transmitter

Hereinafter, an operation of a transmitter according to a first embodiment of the present invention will be described with reference to the accompanying drawings.

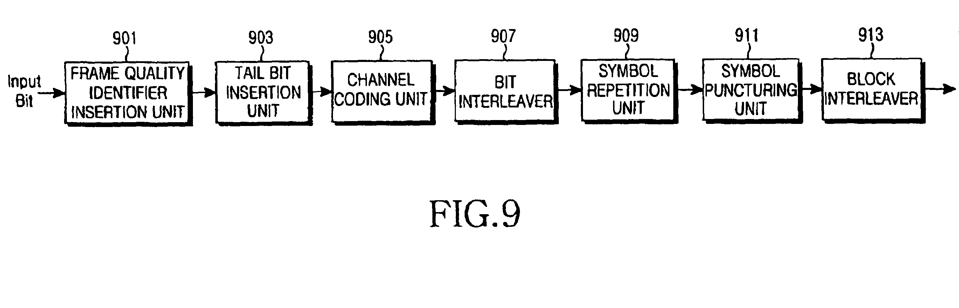

FIG. 9 is a block diagram illustrating the transmitter for providing a high-speed packet data service (IxEV-DV) in a synchronous mobile communication system according to the first embodiment of the present invention.

Referring to FIG. 9, a bit signal, to which a frame quality identifier and a tail bit are added by means of blocks 901 and 903, is output in the form of a coded bit array through a channel coding unit 905. Then, the coded bit array is transferred to a bit interleaver 907 so that the bit interleaver 907 performs a bit interleaving with respect to the coded bit array. After that, a rate matching is performed with respect to the coded bit array through a symbol repetition block 909 and a symbol puncturing block 911. During the rate matching process, a coded bit array to be transmitted through the physical channel is determined. Thus, the coded bit array determined to be transmitted through the physical channel undergoes a block interleaving by means of a block interleaver 913, and then, is mapped with the corresponding physical channel.

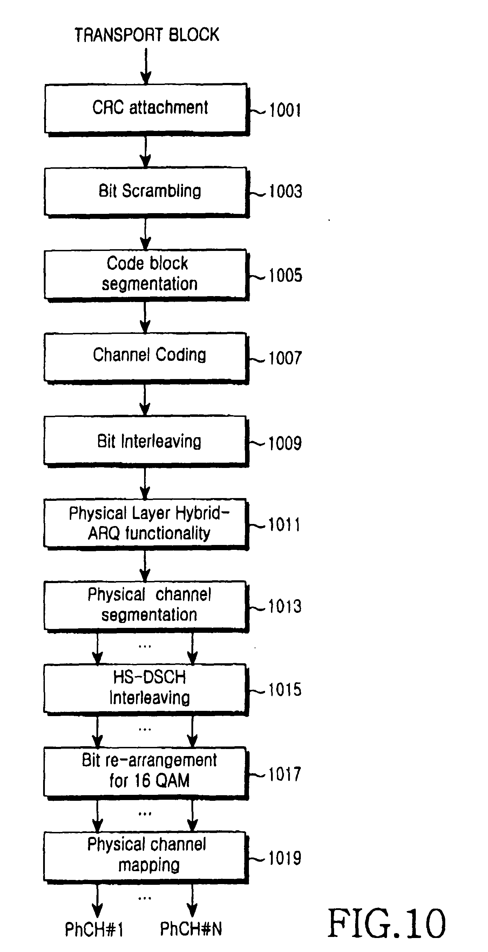

FIG. 10 is a block diagram illustrating a transmitter for providing a high-speed downlink packet access (HSDPA) in an asynchronous mobile communication system according to a first embodiment of the present invention.

Referring to FIG. 10, a block 1001 creates a cyclic redundancy check (CRC) with respect to a transport block being input and attaches the CRC to the transport block. The transport block having the CRC undergoes a bit scrambling by means of a block 1003. The bit scrambling is necessary to solve an unevenness of average power of a transport symbol generated in a higher modulation scheme. Then, the transport block is segmented into code blocks that match a size of an internal interleaver of the channel coding unit of a block 1005. Thereafter, a block 1007 performs a channel coding with respect to the code blocks so that the code blocks are output in the form of a coded bit array. In addition, a block 1009 performs a bit interleaving with respect to each bit of the coded bit array output from the block 1007. That is, positions of the coded bits are changed with each other in the code bit array while passing through the block 1009 so that performance degradation caused by the periodicity of the coded bits derived from a channel coding characteristic can be eliminated. In particular, the block 1009 can prevent performance degradation during a channel decoding by allowing the coded bits to have a period, which does not match a puncturing period for a rate matching. After that, the coded bit array is transferred to a block 1011 so that the coded bit array undergoes AMC or IR for supporting the HARQ.

That is, the coded bits for the HARQ are selectively output from the block 1011. The coded bit array output from the block 1011 is segmented by means of a block 1013 in such a manner that the coded bits have a size adaptable for the physical channel. Then, the coded bit array is transferred to the block 1015. Each segmented coded bit array is interleaved through the block 1015, and then, is mapped with the corresponding physical channel. The coded bits mapped with the physical channels are rearranged through a block 1017 for a 16 QAM modulation scheme, and then, mapped with the corresponding physical channels through a block 1019. After that, the coded bits are finally output through the block 1019.

Hereinafter, the description will now be made with respect to the bit interleaver according to the first embodiment of the present invention.

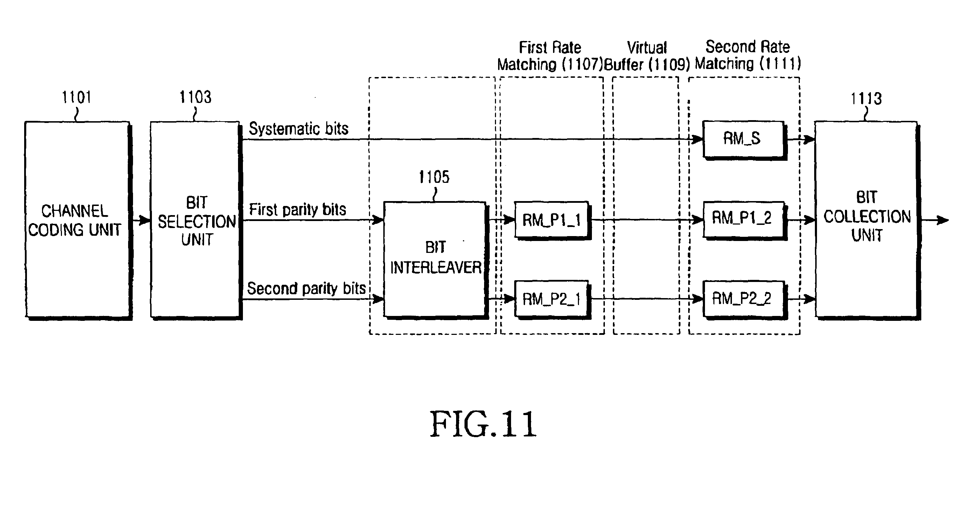

FIG. 11 is a block view showing a bit interleaver for parity bits of the coded bit array according to the first embodiment of the present invention.

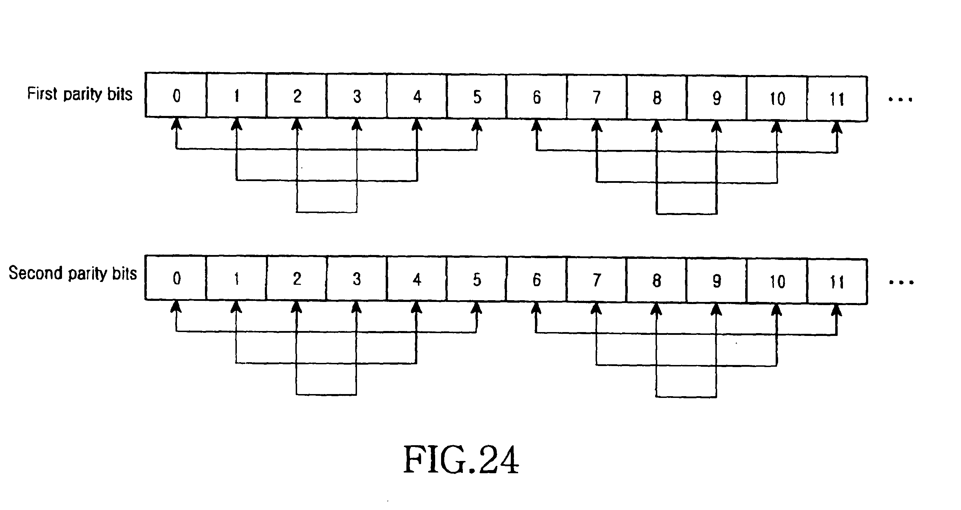

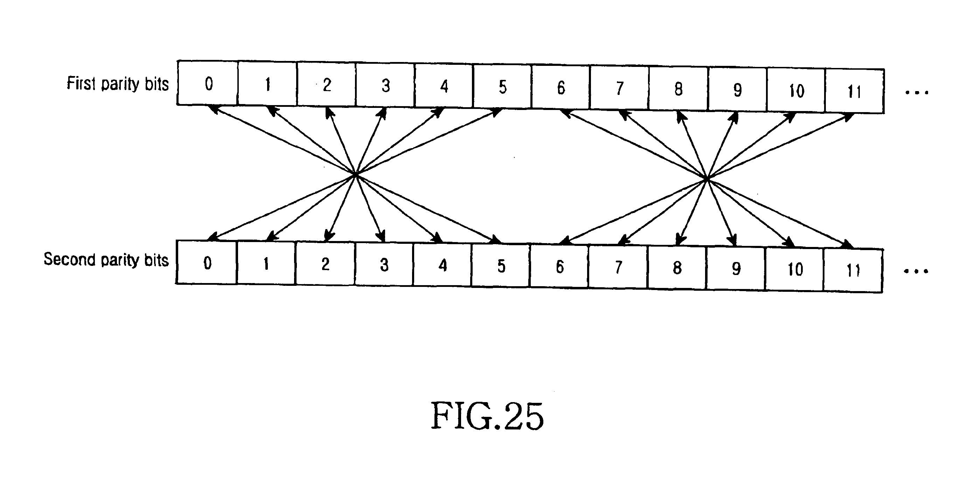

Referring to FIG. 11, a channel coding unit 1101 outputs a coded bit array by performing a channel coding with respect to bits being input thereto. FIG 11 shows one systematic bit array and two parity bit arrays. The systematic bit array is transferred to a second rate matching unit 1111 through a virtual buffer 1109 without being subject to a bit interleaving process and a first rate matching process. However, the parity bit arrays are transferred to a bit interleaver 1105 from bit selection unit 1103. The bit interleaver 1105 performs a bit interleaving with respect to each parity bit array. The bit interleaving may be performed with respect to each parity bit array per several bit units thereof. Thus, as mentioned above, it is possible to prevent the repetition period of the parity bits of each party bit array from matching with the puncturing period of the parity bits for the rate matching. Examples of the bit interleaving for the parity bit arrays are illustrated in FIGS. 24 and 25. Then, the parity bit arrays are transferred to a first rate matching unit 1107 so that the parity bit arrays undergo the rate matching. The first rate matching unit 1107 does not perform the rate matching with respect to the systematic bit array, but perform the rate matching with respect to the first and second parity bit arrays which have undergone the bit interleaving. Due to the rate matching performed by means of the first rate matching unit 1107, output bits may match with a size of the virtual buffer 1109 used for each user. The virtual buffer 1109 stores coded bits for retransmission. The second rate matching section 1111 performs a rate matching with respect to the systematic bit array stored in the virtual buffer 1109 and first and second parity bit arrays, which have undergone the rate matching by means of the first rate matching unit, in order to determine coded bits to be transmitted through the physical channel. Thus, the number of coded bits output from the second rate matching unit 1111 matches the number of coded bits transmitted through the physical channel. In addition, the second rate matching section 1111 changes a pattern of the coded bits being output according to a transmission mode, such as an initial transmission mode or a retransmission mode, in order to support the HARQ. A bit collection unit 1113 is provided to rearrange three bit arrays output from the second rate matching unit 1111 into one bit array.

Although FIG. 11 shows one bit interleaver for the parity bit arrays, it is also possible to provide a plurality of bit interleavers for each parity bit array.

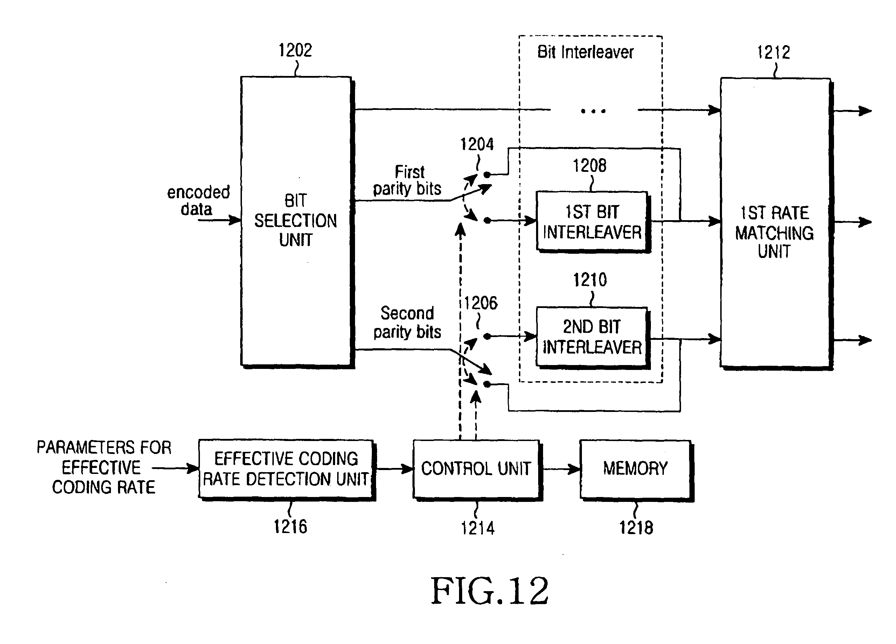

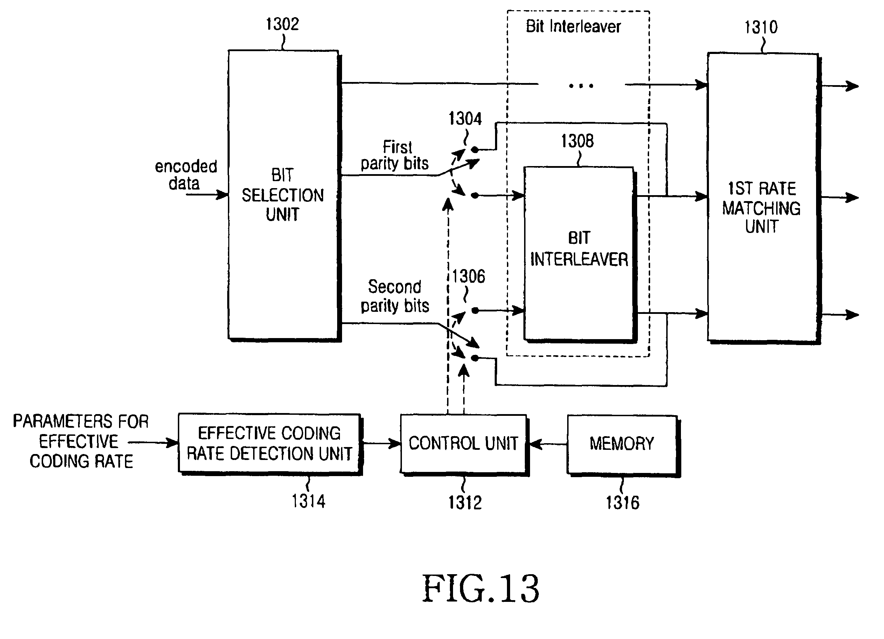

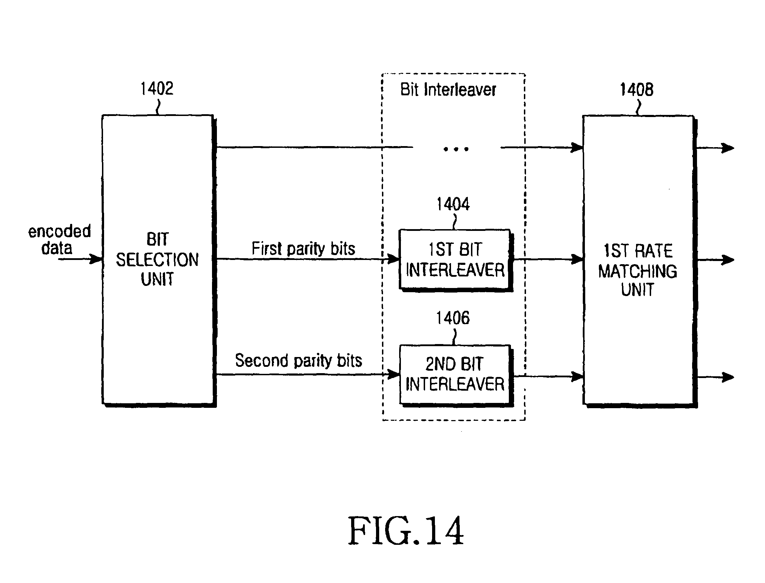

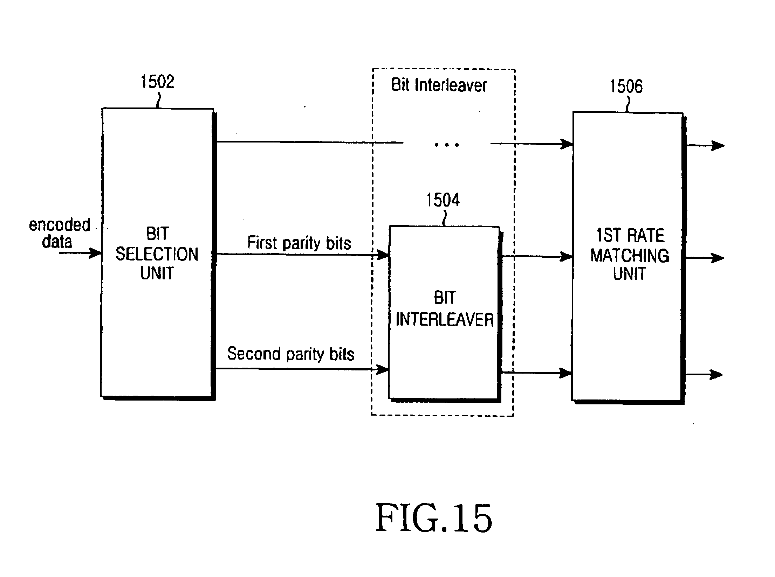

FIGS. 12 to 15 are block diagrams illustrating various bit interleavers according to the first embodiment of the present invention. FIGS. 12 and 13 show cases in which the bit interleaving is selectively performed depending on an environment causing performance degradation, and FIGS. 14 and 15 show cases in which the bit interleaving is performed regardless of the environment causing performance degradation. Meanwhile, FIGS. 12 and 14 show bit interleavers provided for each parity bit array and FIGS. 13 and 15 shows a common interleaver provided for parity bit arrays.

Referring now to FIG. 12, the coded bit array output from a channel coding unit (not shown) is divided into one systematic bit array and two parity bit arrays by means of a bit selection unit 1202. The systematic bit array is transferred to a first rate matching unit 1212 without passing through a bit interleaver. In contrast, two parity bit arrays are transferred to two different bit interleavers, respectively. That is, the first parity bit array is transferred to a first bit interleaver 1208 and the second parity bit array is transferred to a second bit interleaver 1210. The first bit interleaver 1208 performs the bit interleaving with respect to the first parity bit array per predetermined bit units thereof. The second bit interleaver 1210 performs the bit interleaving with respect to the second parity bit array per predetermined bit units thereof. The bit interleaving performed by means of the first and second bit interleavers 1208 and 1210 will be described in detail with reference to FIG. 24, later. The first and second parity bit arrays are transferred to the first and second bit interleavers 1208 and 1210 by means of first and second switches 1204 and 1206. That is, the first parity bit array is transferred to the first rate matching unit 1212 or the first bit interleaver 1208 by means of the first switch 1204. In addition, the second parity bit array is transferred to the first rate matching unit 1212 or the second bit interleaver 1210 by means of the second switch 1206. The first and second switches 1204 and 1206 are controlled based on a matching state between the repetition period of the parity bit array and the puncturing period of the parity bit array for the rate matching. It is possible to determine the matching state between the repetition period of the parity bit array and the puncturing period of the parity bit array by using an effective coding rate. If a control unit 1214 has data for a specific effective coding rate causing the matching state between the repetition period and the puncturing period of the parity bit array, the control unit 1214 may determine whether or not a present effective coding rate matches the specific effective coding rate and may control the first and second switches 1204 and 1206 based on the above determination.

That is, if the present effective coding rate matches with the specific effective coding rate, the control unit 1214 controls the first and second switches 1204 and 1206 such that the parity bit arrays can be transferred to the first and second bit interleavers 1208 and 1210. In addition, if the present effective coding rate does not match with the specific effective coding rate, the control unit 1214 controls the first and second switches 1204 and 1206 such that the parity bit arrays can be transferred to the first rate matching unit 1212. Thus, the control unit 1214 must know the present effective coding rate in order to control the first and second switches 1204 and 1206. The effective coding rate is calculated at a transmission terminal by using an amount of systematic bits (transport block size), the number of physical channels according to the number of available orthogonal variable spreading factors (OVSFs), and the modulation scheme. In addition, a receiving terminal calculates the effective coding rate in advance by receiving the above parameters from the transmission terminal through a predetermined control channel. The following is an example for calculating the effective coding rate.

Effective coding rate = (an amount of systematic bits (transport block size))/(the number of OVSFs $\times$ the number of bits to be transmitted through the physical channel).

The number of bits to be transmitted through the physical channel is calculated according to the modulation scheme.

The total number of bits after the rate matching = (the number of OVSFs $\times$ the number of bits to be transmitted through the physical channel).

For example, in a case of the receiving terminal, the effective coding rate can be calculated by using the parameters transmitted to the receiving terminal from a base station through a common control channel.

The parameters for the effective coding rate are transferred to an effective coding rate detection unit 1216 so that the effective coding rate detection unit 1216 detects information about the effective coding rate from the parameters. The detected information is transferred to the control unit 1214. The control unit 1214 must know the specific effective coding rate causing performance degradation in order to control the first and second switches 1204 and 1206. The specific effective coding rate is stored in a memory 1218. Thus, the control unit 1214 obtains the specific effective coding rate from the memory 1218 and determines whether or not the present effective coding rate is identical to the specific effective coding rate. The control unit 1214 controls the first and second switches 1204 and 1206 based on the above determination. Although FIG. 12 shows a special structure for obtaining the present effective coding rate, the present effective coding rate can be calculated in the control unit 1214 without providing the special structure.

The first rate matching unit 1212 performs the rate matching with respect to the systematic bit array and parity bit arrays transferred from the bit selection unit 1202 or the first and second bit interleavers 1208 and 1210.

Referring to FIG. 13, the coded bit array output from a channel coding unit (not shown) is divided into one systematic bit array and two parity bit arrays by means of a bit selection unit 1302. The systematic bit array is transferred to a first rate matching unit 1310 without passing through a bit interleaver. In contrast, two parity bit arrays are transferred to a bit interleaver 1308. The bit interleaver 1308 performs the bit interleaving with respect to the first and the second parity bit arrays per predetermined bit units thereof. The bit interleaving performed by means of the bit interleaver 1308 will be described in detail with reference to FIG. 25, later. The first and second parity bit arrays are transferred to the bit interleaver 1308 by means of first and second switches 1304 and 1306. That is, the first parity bit array is transferred to the first rate matching unit 1310 or the bit interleaver 1308 by means of the first switch 1304. In addition, the second parity bit array is transferred to the first rate matching unit 1310 or the bit interleaver 1308 by means of the second switch 1306. The first and second switches 1304 and 1306 are controlled based on a matching state between the repetition period of the parity bit array and the puncturing period of the parity bit array for the rate matching. It is possible to determine the matching state between the repetition period of the parity bit array and the puncturing period of the parity bit array by using an effective coding rate. If the present effective coding rate is identical to the specific effective coding rate, a control unit 1312 controls the first and second switches 1304 and 1306 such that the parity bit arrays can be transferred to the bit interleaver 1308. In addition, if the present effective coding rate does not match with the specific effective coding rate, the control unit 1312 controls the first and second switches 1304 and 1306 such that the parity bit arrays can be transferred to the first rate matching unit 1310. Thus, the control unit 1312 must know the present effective coding rate in order to control the first and second switches 1304 and 1306. As mentioned above, the present effective coding rate is calculated by using parameters determining the effective coding rate received in a receiving terminal through an upper layer or a predetermined control channel. That is, the parameters for the effective coding rate are transferred to an effective coding rate detection unit 1314 so that the effective coding rate detection unit 1314 detects information about the effective coding rate from the parameters. The detected information is transferred to the control unit 1312,

Meanwhile, the control unit 1312 must know the specific effective coding rate in order to control the first and second switches 1304 and 1306. The specific effective coding rate is stored in a memory 1316. Thus, the control unit 1312 obtains the specific effective coding rate from the memory 1316 and determines whether or not the present effective coding rate is identical to the specific effective coding rate. In addition, the control unit 1312 controls the first and second switches 1304 and 1306 based on the above determination. Although FIG. 13 shows a special structure for obtaining the present effective coding rate, the present effective coding rate can be calculated in the control unit 1312 without providing the special structure.

The first rate matching unit 1310 performs the rate matching with respect to the systematic bit array and parity bit arrays transferred from the bit selection unit 1302 or the bit interleaver 1308.

Referring to FIG 14, the coded bit array output from a channel coding unit (not shown) is divided into one systematic bit array and two parity bit arrays by means of a bit selection unit 1402. The systematic bit array is transferred to a first rate matching unit 1408 without passing through a bit interleaver. In contrast, two parity bit arrays are transferred to two different bit interleavers, respectively. That is, the first parity bit array is transferred to a first bit interleaver 1404 and the second parity bit array is transferred to a second bit interleaver 1406. The first bit interleaver 1404 performs the bit interleaving with respect to the first parity bit array per predetermined bit units thereof. The second bit interleaver 1406 performs the bit interleaving with respect to the second parity bit array per predetermined bit units thereof. The bit interleaving performed by means of the first and second bit interleavers 1404 and 1406 will be described in detail with reference to FIG. 24, later. The first rate matching unit 1408 performs the rate matching with respect to the systematic bit array and the parity bit arrays, which are transferred from the first and second bit interleavers 1404 and 1406 and have undergone the bit interleaving.

Referring to FTG. 15, the coded bit array output from a channel coding unit (not shown) is divided into one systematic bit array and two parity bit arrays by means of a bit selection unit 1502. The systematic bit array is transferred to a first rate matching unit 1506 without passing through a bit interleaver. In contrast, two parity bit arrays are transferred to a bit interleaver 1504. The bit interleaver 1504 performs the bit interleaving with respect to the first and second parity bit arrays per predetermined bit units thereof. The bit interleaving performed by means of the bit interleaver 1504 will be described in detail with reference to FIG. 25, later. The first rate matching unit 1506 performs the rate matching with respect to the systematic bit array and the parity bit arrays, which are transferred from the bit interleaver 1504 and have undergone the bit interleaving.

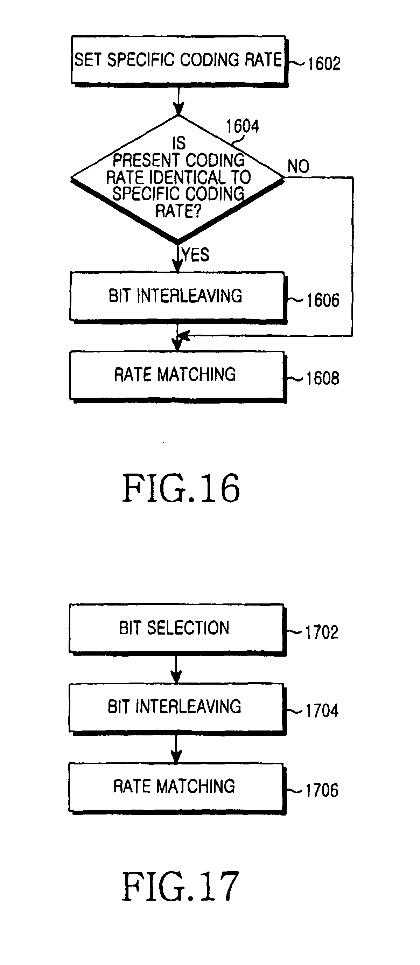

FIG. 16 is a flowchart illustrating an operation of a transmitter corresponding to FIG. 12 and FIG 17 is a flowchart illustrating an operation of a transmitter corresponding to FIGS. 14 and 15.

Referring to FIG. 16, a specific effective coding rate causing performance degradation during a channel decoding is calculated in step 1602. Then, after checking a present effective coding rate, it is determined whether or not the present effective coding rate is identical to the specific effective coding rate in step 1604. If the present effective coding rate is identical to the specific effective coding rate, step 1606 is performed. Otherwise, step 1608 is performed. In step 1606, the bit interleaving is performed with respect to the parity bit arrays, thereby changing the repetition period of the parity bit arrays. In step 1608, the rate matching is performed with respect to the parity bit arrays.

Although FIG. 16 shows that the bit interleaving is performed with respect to the parity bit arrays only when the present effective coding rate is identical to the specific effective coding rate, it is also possible to perform the bit interleaving with respect to the parity bit arrays regardless of the effective coding rate. In this case, steps 1602 and 1604 can be omitted.

Referring to FIG. 17, a systematic bit array and a plurality of parity bit arrays are selectively output from a channel coding unit in step 1702. Then, the bit interleaving is performed with respect to the parity bit arrays in step 1704. In addition, the rate matching is performed with respect to the systematic bit array and the parity bit arrays in which the repetition period is changed through the bit interleaving in step 1706.

<u>Receiver</u>

Hereinafter, an operation of a receiver according to a first embodiment of the present invention will now be described with reference to the accompanying drawings.

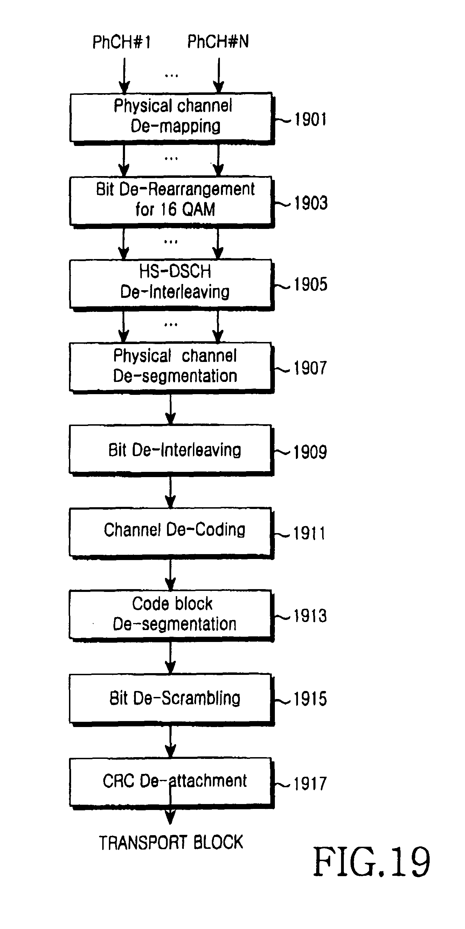

FIG. 19 is a block diagram illustrating a receiver used for an HSDAP service of an asynchronous mobile communication system according to a first embodiment of the present invention.

Referring to FIG. 19, coded bits mapped with a plurality of physical channels (PhCH#1 to PhCH#N) are de-mapped in a block 1901 and output through the block 1901. Then, the coded bits, which are de-mapped from the physical channels (PhCH#1 to PhCH#N), are rearranged by means of a block 1903 for a 16QAM modulation scheme. After that, a block interleaving is performed with respect to the rearranged coded bit arrays through a block 1905. The coded bit arrays, which have undergone the block interleaving, are unified as one coded bit array through a block 1907 and transferred to a block 1909.

In the block 1909, bit de-interleaving is performed with respect to coded bits of the coded bit array output through the block 1907. That is, positions of the coded bits are changed with each other in the code bit array while passing through the block 1909 so that the coded bit array is rearranged in the form of an initial coded bit array which does not undergo the bit interleaving process in the transmitter. In other words, the block 1909 eliminates a problem caused by the periodicity of the coded bits derived from a channel coding characteristic. Thus, the block 1909 can prevent performance degradation during a channel decoding by allowing the coded bits to have a period, which docs not match a puncturing period for a rate matching.

The coded bit array, which has undergone the bit de-interleaving, is transferred to a block 1911 so that the channel decoding is performed with respect to the coded bit array. The bit arrays decoded in the form of code block units are coupled to a block 1913 and are output in the form of transport block units. Then, a bit de-scrambling is performed with respect to the bit array in the form of transport block units by means of a block 1915. In addition, CRC bits attached to the bit array, which has undergone the bit de-scrambling, are detached from the bit array by means of a block 1917 and transferred to an upper layer as transport blocks.

Hereinafter, examples of bit de-interleavers in a receiver when a channel coding unit has a coding rate of 1/3 will be described in detail. It should be noted that the bit de-interleavers described below can be used for a channel decoding even if the channel coding unit has various coding rates, other than 1/3.

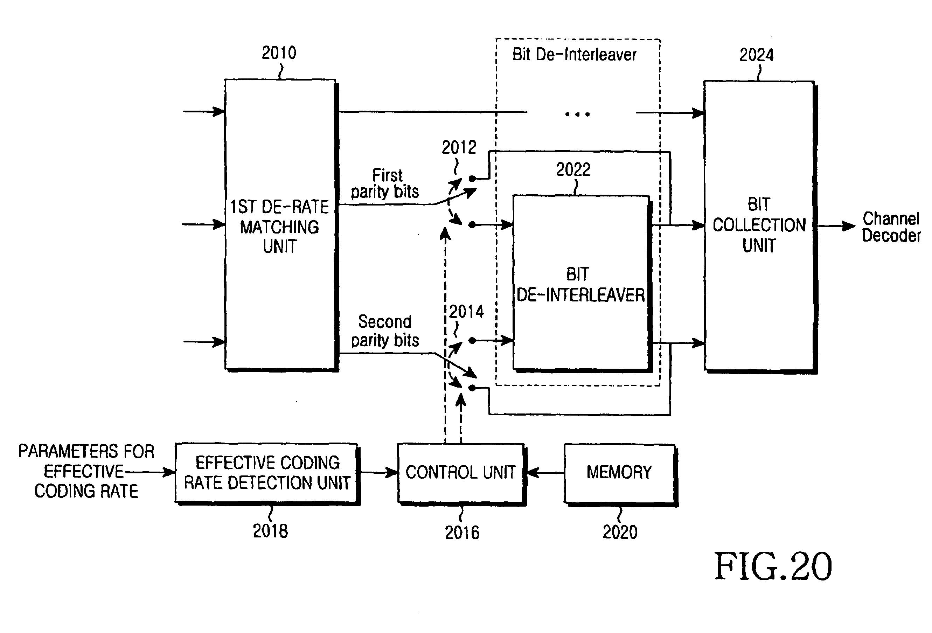

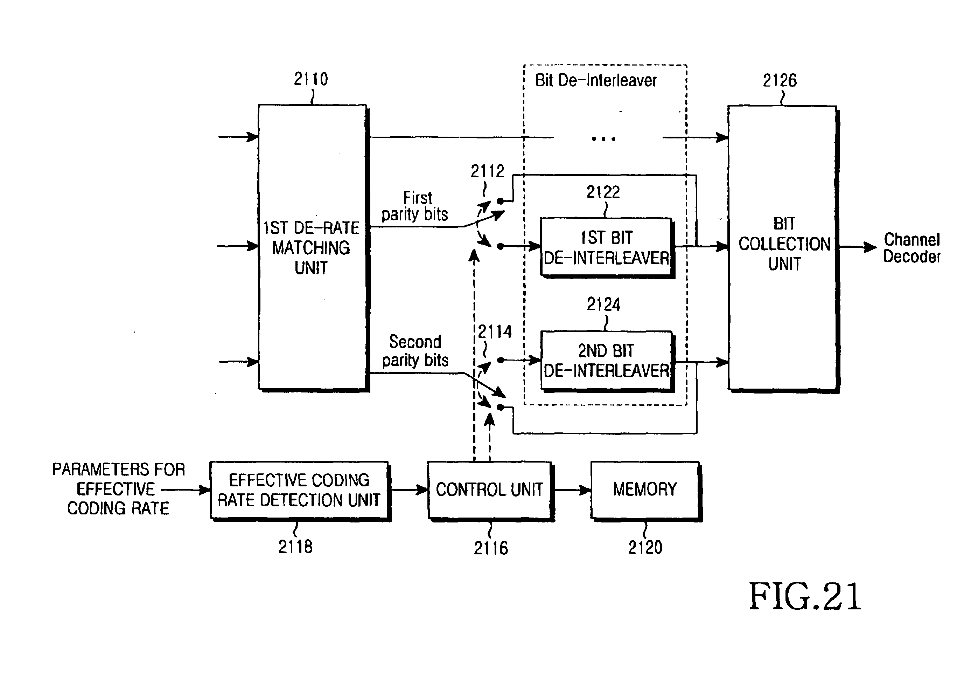

FIGS. 20 and 21 are block diagrams illustrating various bit de-interleavers according to a first embodiment of the present invention. FIGS. 20 and 21 show examples of selective bit de-interleaving depending on an environment causing performance degradation.

FIG. 20 shows a common bit de-interleaver for parity bit arrays.

Referring to FIG. 20, a received coded bit array is rearranged in the form of an initial coded bit array, which does not undergo the rate matching in the transmitter, by means of a first de-rate matching unit 2010. The rearranged coded bit array is divided into one systematic bit array and two parity bit arrays. The systematic bit array is transferred to a bit collection unit 2024 without passing through a bit de-interleaver. In contrast, two parity bit arrays are transferred to a bit de-interleaver 2022. The bit de-interleaver 2022 performs a bit de-interleaving with respect to the first and the second parity bit arrays per predetermined bit units thereof. The bit de-interleaving performed by means of the bit de-interleaver 2022 will be described in detail with reference to FIG. 25, later. The first and second parity bit arrays are transferred to the bit de-interleaver 2022 by means of first and second switches 2012 and 2014. That is, the first parity bit array is transferred to the bit collection unit 2024 or the bit de-interleaver 2022 by means of the first switch 2012. In addition, the second parity bit array is transferred to the bit collection unit 2024 or the bit de-interleaver 2022 by means of the second switch 2014. The first and second switches 2012 and 2014 are controlled based on a matching state between the repetition period of the parity bit array and the puncturing period of the parity bit array for the rate matching. It is possible to determine the matching state between the repetition period of the parity bit array and the puncturing period of the parity bit array by using an effective coding rate. If a present effective coding rate is identical to a specific effective coding rate causing a problem of the puncturing periodicity, a control unit 2016 controls the first and second switches 2012 and 2014 such that the parity bit arrays can be transferred to the bit de-interleaver 2022. In addition, if the present effective coding rate does not match with the specific effective coding rate, the control unit 2016 controls the first and second switches 2012 and 2014 such that the parity bit arrays can be transferred to the bit collection unit 2024. Thus, the control unit 2016 must know the present effective coding rate in order to control the first and second switches 2012 and 2014. The present effective coding rate is calculated by using parameters determining the effective coding rate transmitted to a receiver from a transmitter through an upper layer or a predetermined control channel. In detail, the parameters for determining the effective coding rate are transferred to an effective coding rate detection unit 2018 so that the effective coding rate detection unit 2018 detects information about the effective coding rate from the parameters. The detected information is transferred to the control unit 2016.

The control unit 2016 must know the specific effective coding rate in order to control the first and second switches 2012 and 2014. The specific effective coding rate is stored in a memory 2020. Thus, the control unit 2016 obtains the specific effective coding rate from the memory 2020 and determines whether or not the present effective coding rate is identical to the specific effective coding rate. The control unit 2016 controls the first and second switches 2012 and 2014 based on the above determination. Although FIG. 20 shows a special structure for obtaining the present effective coding rate, the present effective coding rate can be calculated in the control unit 2016 without providing the special structure.

The bit collection unit 2024 outputs the systematic bit array and parity bit arrays transferred from the first de-rate matching unit 2010 or the bit de-interleaver 2022 by unifying the systematic bit array and parity bit arrays as one coded bit array.

FIG. 21 shows bit de-interleavers provided for parity bit arrays, respectively.

Referring to FIG. 21, a received coded bit array is rearranged in the form of an initial coded bit array, which does not undergo the rate matching in the transmitter, by means of a first de-rate matching unit 2110. The rearranged coded bit array is divided into one systematic bit array and two parity bit arrays. The systematic bit array is transferred to a bit collection unit 2126 without passing through a bit de-interleaver. In contrast, a first parity bit array of two parity bit arrays is transferred to a first bit de-interleaver 2122 and a second parity bit array of two parity bit arrays is transferred to a second bit de-interleaver 2124. The first bit de-interleaver 2122 performs a bit de-interleaving with respect to the first parity bit array per predetermined bit units thereof. In addition, the second bit de-interleaver 2124 performs a bit de-interleaving with respect to the second parity bit array per predetermined bit units thereof. The bit de-interleaving performed by means of the first and second bit de-interleavers 2122 and 2124 will be described in detail with reference to FIG 24, later. The first and second parity bit arrays are transferred to the first and second bit de-interleavers 2122 and 2124 by means of first and second switches 2112 and 2114. That is, the first parity bit array is transferred to the bit collection unit 2126 or the first bit de-interleaver 2122 by means of the first switch 2112. In addition, the second parity bit array is transferred to the bit collection unit 2126 or the second bit de-interleaver 2124 by means of the second switch 2114. The first and second switches 2112 and 2114 are controlled based on a matching state between the repetition period of the parity bit array and the puncturing period of the parity bit array for the rate matching. It is possible to determine the matching state between the repetition period of the parity bit array and the puncturing period of the parity bit array by using an effective coding rate. If a present effective coding rate is identical to a specific effective coding rate causing a problem of puncturing periodicity, a control unit 2116 controls the first and second switches 2112 and 2114 such that the first and second parity bit arrays can be transferred to the first and second bit de-interleaver 2122 and 2124. In addition, if the present effective coding rate does not match with the specific effective coding rate, the control unit 2116 controls the first and second switches 2112 and 2114 such that the first and second parity bit arrays can be transferred to the bit collection unit 2126. Thus, the control unit 2116 must know the present effective coding rate in order to control the first and second switches 2112 and 2114. The present effective coding rate is calculated by using parameters determining the effective coding rate transmitted to a receiver from a transmitter through an upper layer or a predetermined control channel. In detail, the parameters for determining the effective coding rate are transferred to an effective coding rate detection unit 2118 so that the effective coding rate detection unit 2118 detects information about the effective coding rate from the parameters. The detected information is transferred to the control unit 2116.

The control unit 2016 must know the specific effective coding rate in order to control the first and second switches 2112 and 2114. The specific effective coding rate is stored in a memory 2120. Thus, the control unit 2116 obtains the specific effective coding rate from the memory 2120 and determines whether or not the present effective coding rate is identical to the specific effective coding rate. The control unit 2116 controls the first and second switches 2112 and 2114 based on the above determination. Although FIG. 21 shows a special structure for obtaining the present effective coding rate, the present effective coding rate can be calculated in the control unit 2016 without providing the special structure.

The bit collection unit 2126 outputs the systematic bit array and parity bit arrays transferred from the first de-rate matching unit 2 110 or the first and second bit de-interleavers 2122 and 2124 by unifying the systematic bit array and parity bit arrays as one coded bit array.

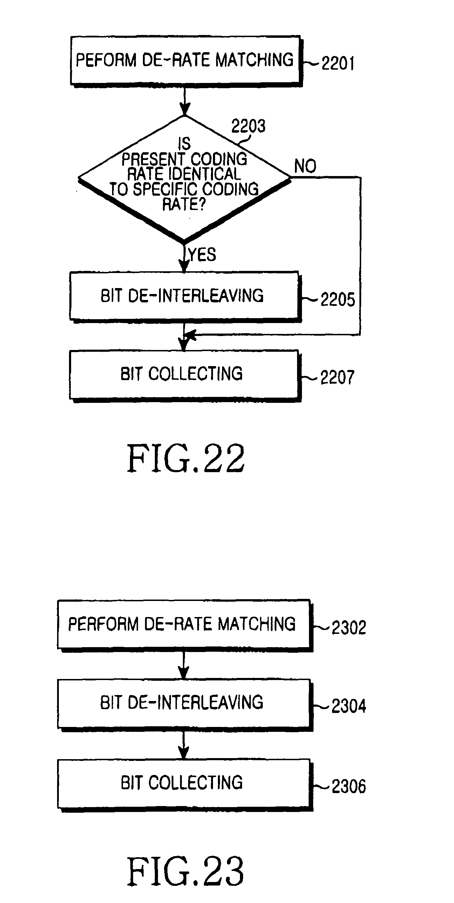

FIG. 22 is a flowchart showing an operation of a receiver according to a first embodiment of the present invention in which a bit de-interleaving is selectively performed at a specific coding rate.

Referring to FIG. 22, a de-rate matching is performed with respect to received coded bits in step 2201. Then, after checking a present effective coding rate, it is determined whether or not the present effective coding rate is identical to a specific effective coding rate in step 2203. If the present effective coding rate is identical to the specific effective coding rate, step 2205 is performed. Otherwise, step 2207 is performed. In step 2205, the bit de-interleaving is performed with respect to the parity bit arrays selected from the coded bit arrays, thereby outputting the parity bit array arranged identical to the initial coded bit array, which does not undergo the beat interleaving in the transmitter. In step 2207, one coded bit array is output by unifying the parity bit arrays with the systematic bit array through a bit collection. The above mentioned coded bit array is decoded through a channel decoding process.

Although FIG. 22 shows that the bit de-interleaving is performed with respect to the parity bit arrays only when the present effective coding rate is identical to the specific effective coding rate, it is also possible to perform the bit de-interleaving with respect to the parity bit arrays regardless of the effective coding rate. FIG 23 is a flowchart showing an operation of a receiver performing the bit de-interleaving regardless of the effective coding rate according to a first embodiment of the present invention.

Referring to FIG. 23, a de-rate matching is performed with respect to received coded bits in step 2302. Then, the bit de-interleaving is performed with respect to the parity bit arrays selected from the coded bit arrays, thereby outputting the parity bit array arranged identical to the initial coded bit array, which does not undergo the beat interleaving in the transmitter in step 2304. In addition, one coded bit array is output by unifying the parity bit arrays, which have undergone the bit de-interleaving, with the systematic bit array through a bit collection in step 2306.

FIG. 24 shows an example of the bit interleaving/bit de-interleaving when bit interleavers or bit de-interleavers are provided for parity bit arrays, respectively, and FIG. 25 shows an example of the bit interleaving/bit de-interleaving when one bit interleaver or one bit de-interleaver is provided for the parity bit arrays. In FIGS. 24 and 25, a bit unit for the bit interleaving/bit de-interleaving is set to 6.

Referring to FIG. 24, a first parity bit in a first parity array and a sixth parity bit in a second parity bit array change their positions with each other, and a first parity bit of the second parity bit array and a sixth parity bit of the first parity bit array change their positions with each other. In addition, a second parity bit in the first parity array and a fifth parity bit in the second parity bit array change their positions with each other and a second parity bit in the second parity array and a fifth parity bit in the first parity bit array change their positions with each other. Also, a third parity bit in the first parity array and a fourth parity bit in the second parity bit array change their positions with each other and a third parity bit in the second parity array and a fourth parity bit in the first parity bit array change their positions with each other. The above bit interleaving is repeatedly performed with a period of 6 parity bits.

Embodiment 2

Hereinafter, a second embodiment of the present invention will now be described with reference to the accompanying drawings.

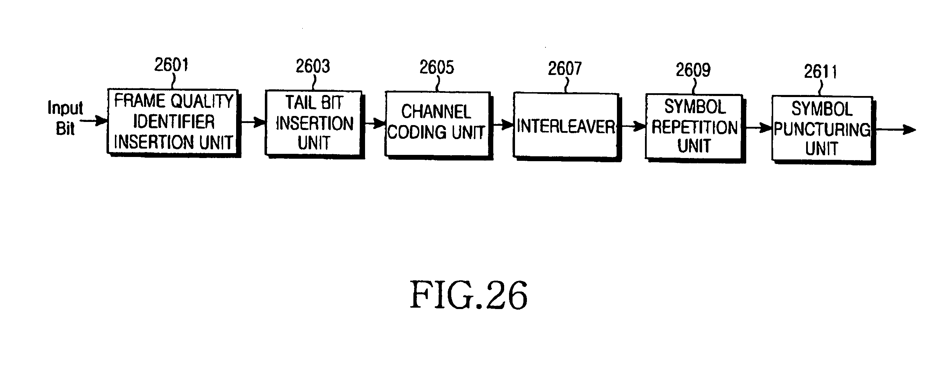

FIG. 26 is a block diagram illustrating a transmitter for providing a high-speed packet data service (JxEV-DV) in a synchronous mobile communication system according to the second embodiment of the present invention.

Referring to FIG. 26, a bit signal, to which a frame quality identifier and a tail bit are added by means of blocks 2601 and 2603, is output in the form of a coded bit array through a channel coding unit 2605. Then, the coded bit array is transferred to an interleaver 2607 so that the coded bit array undergoes a bit interleaving and a block interleaving. After that, a rate matching is performed with respect to the coded bit array through a symbol repetition block 2609 and a symbol puncturing block 2611. During the rate matching process, a coded bit array to be transmitted through the physical channel is determined. Thus, the coded bit array determined to be transmitted through the physical channel is mapped with the corresponding physical channel.

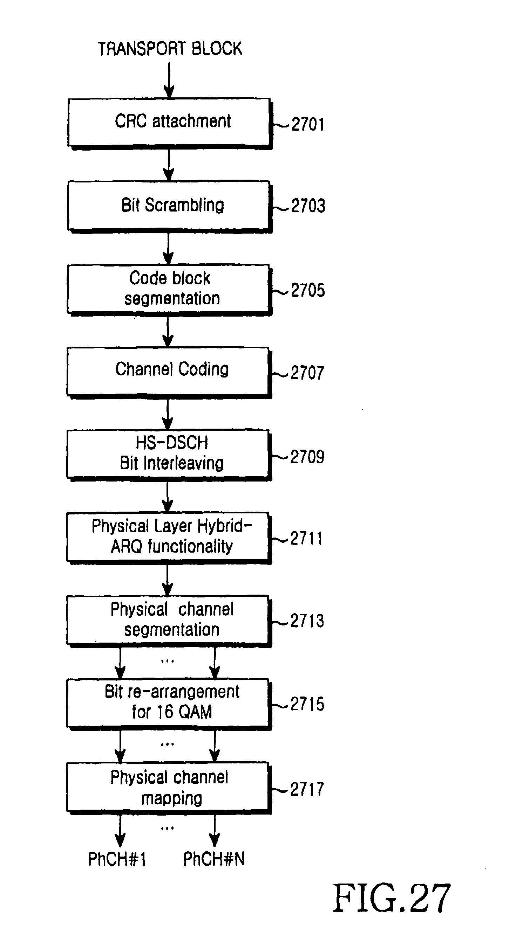

FIG. 27 is a block diagram illustrating a transmitter for providing an HSDPA in an asynchronous mobile communication system according to a second embodiment of the present invention.

Referring to FIG. 27, a block 2701 creates a CRC with respect to a transport block being input thereto and attaches the CRC to the transport block. The transport block having the CRC undergoes a bit scrambling by means of a block 2703. The bit scrambling is necessary to solve an unevenness of average power of a transport symbol generated in a higher modulation scheme. Then, the transport block, which has undergone the bit scrambling, is segmented into code blocks in match with a size of an internal interleaver of the channel coding unit of a block 2705. Thereafter, a block 2707 performs a channel coding with respect to the code blocks so that the code blocks are output to a block 2709 in the form of a coded bit array. Thus, the block 2709 performs a bit interleaving and a block interleaving with respect to each bit of the coded bit array output from the block 2707. That is, the coded bits are mixed with each other in predetermined bit units and block units while passing through the block 2709 so that performance degradation caused by the periodicity of the coded bits derived from a channel coding characteristic can be eliminated. In particular, the block 2079 can prevent performance degradation during a channel decoding by allowing the coded bits to have a period, which does not match a puncturing period for a rate matching. In addition, the blocking interleaving is performed simultaneously with the bit interleaving for preventing a burst error. The coded bit array, which has undergone the interleaving, is transferred to a block 2711 so that the coded bit array undergoes an adaptive modulation and coding scheme (AMC) or incremental redundancy (IR) for supporting the HARQ. That is, the coded bits for the HARQ are selectively output from the block 2711. The coded bit array output from the block 2711 is segmented by means of a block 2713 in such a manner that the coded bits have a size adaptable for the physical channel. Then, the coded bit array is transferred to the block 2715. Each segmented coded bit array is rearranged in the block 2715 for a 16 Quadrature Amplitude Modulation (QAM) modulation scheme. After that, the coded bit array is mapped with the corresponding physical channels through a block 2717 and is finally output through the block 2117.

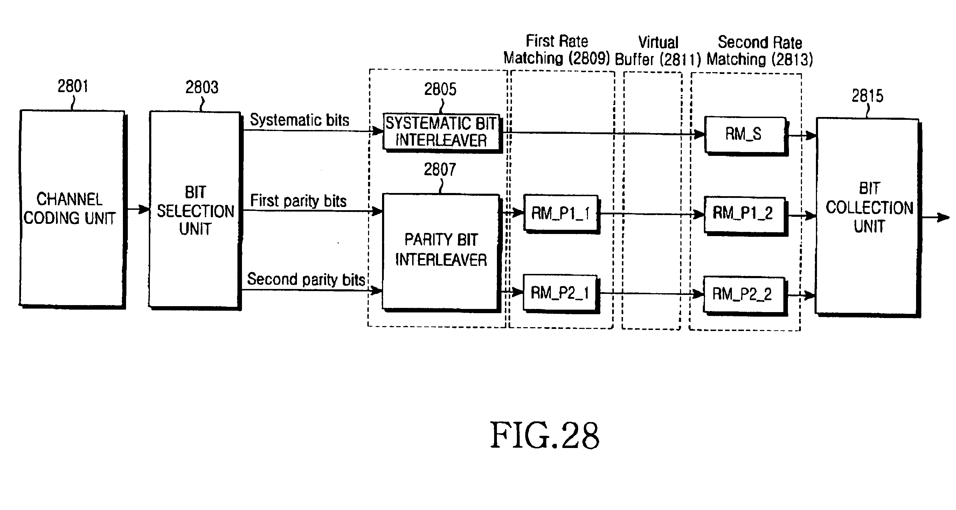

FIG. 28 shows bit interleavers provided for coded bit arrays (systematic bit array and parity bit arrays) according to the second embodiment of the present invention. As shown in FIG. 28, a high speed downlink shared channel (HS-DSCH) interleaver is not provided so that a HS-DSCH interleaving (that is, block interleaving) and the bit interleaving are performed by means of the same interleaver.

Referring to FIG 28, a channel coding unit 2801 outputs coded bit arrays by performing a channel coding with respect to bits being input thereto. According to FIG. 28, one systematic bit array and two parity bit arrays are output from bit selection unit 2803. The systematic bit array is transferred to a systematic bit interleaver 2805, and the parity bit arrays are transferred to a parity bit interleaver 2807. The systematic bit interleaver 2805 performs an interleaving with respect to the systematic bit array. The interleaving may be performed in the same manner as the block interleaving. That is, the interleaving may be performed with respect to the systematic bit array in a block unit. Meanwhile, the parity bit interleaver 2807 simultaneously performs the bit interleaving and the block interleaving with respect to each parity bit array. The bit interleaving is performed in bit units and block units with respect to each parity bit array. As mentioned above, the bit interleaving is necessary to prevent performance degradation of the channel decoder and the burst error created when the repetition period of parity bits matches with the puncturing period of the parity bits in the parity bit array.

The parity bit arrays, which have undergone the interleaving, are transferred to a first rate matching unit 2809 so that the rate matching is performed with respect to the parity bit arrays. The first rate matching unit 2809 does not perform the rate matching with respect to the systematic bit array, which has undergone the interleaving, but perform the rate matching with respect to the first and second parity bit arrays which have undergone the bit interleaving. Due to the rate matching performed by means of the first rate matching unit 2809, output bits may match with a size of the virtual buffer 2811 used for each user. The virtual buffer 2811 stores coded bits for retransmission.

A second rate matching section 2813 performs a rate matching with respect to the systematic bit array, which is stored in the virtual buffer 2811 and has undergone the interleaving, and first and second parity bit arrays, which have undergone the rate matching by means of the first rate matching unit, in order to determine coded bits to be transmitted through the physical channel. Thus, the number of coded bits output from the second rate matching unit 2813 matches with the number of coded bits transmitted through the physical channel. In addition, the second rate matching section 2813 changes a pattern of the coded bits being output according to a transmission mode, such as an initial transmission mode or a retransmission mode, in order to support the HARQ.

A bit collection unit 2815 is provided to rearrange three bit arrays output from the second rate matching unit 2813 into one bit array.

Test result of the present invention

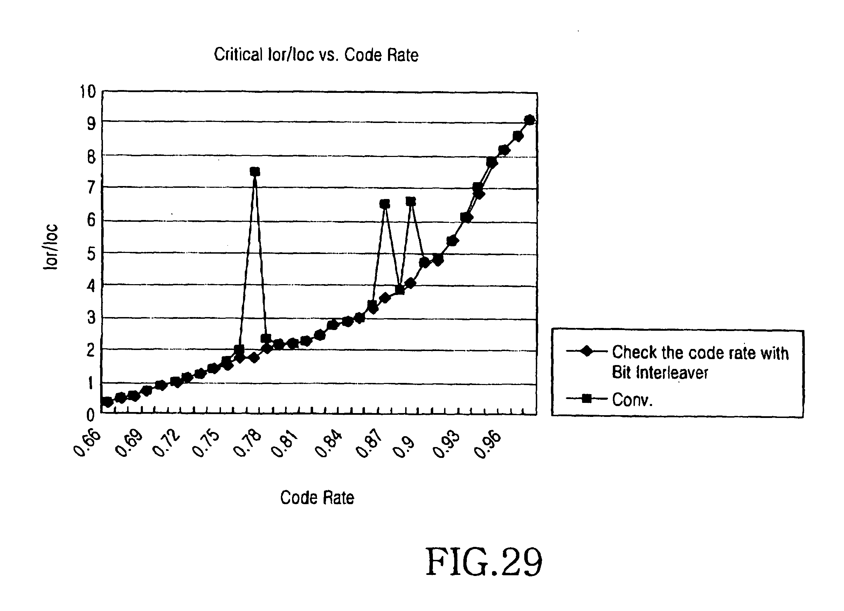

FIG. 29 is a graph illustrating a test result obtained by using the bit interleaver as shown in FIGS. 12 and 13. The test was performed by using a conventional turbo encoder used for the HSDPA and a turbo encoder including a bit interleaver according to the present invention, and power of a base station satisfying 10% of FER was detected at various coding rates.

As shown in FIG 29, the bit interleaver was used only at a specific coding rate causing performance degradation. It should be understood from the test result shown in FIG. 29 that if the bit interleaver is used together with the turbo encoder, the system can stably uses power from the base station. Accordingly, performance of the system can be improved when the bit interleaver is used together with the turbo encoder.

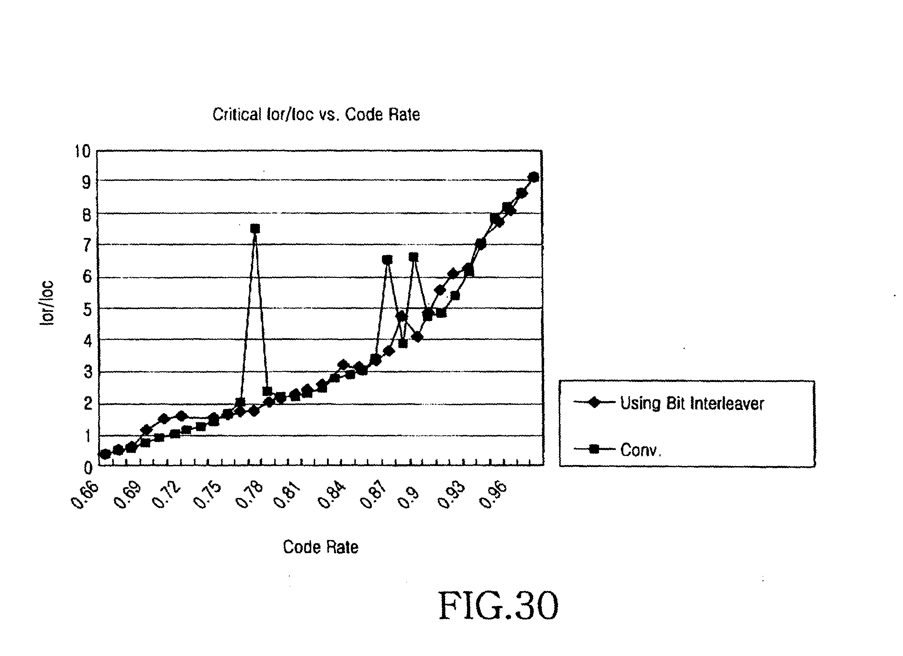

FIG 30 is a graph illustrating a test result obtained by using the bit interleaver as shown in FIGS. 14 and 15. The test was performed by using a conventional turbo encoder used for the HSDPA and a turbo encoder including a bit interleaver according to the present invention, and power of a base station satisfying 10% of frame error rates (PER) were detected at various coding rates.

As shown in FIG. 30, the conventional turbo encoder requires relatively great power in order to satisfy 10% of PER at a specific coding rate, causing performance degradation of the system. However, if the bit interleaver is used together with the turbo encoder, the system can stably use the power of the base station. Accordingly, performance of the system can be improved when the bit interleaver is used together with the turbo encoder.

As described above, according to the embodiments of the present invention, the bit interleaving/bit de-interleaving is performed with respect to coded bits output from the channel encoder, so the repetition period of the coded bits is changed, thereby preventing performance degradation during the channel decoding.

While the invention has been shown and described with reference to certain embodiments thereof, it should be understood by those skilled in the art that various changes in form and details may be made therein without departing from the spirit and scope of the invention as defined by the appended claims.

**Claims**

1. A transmitter for a mobile communication system including a channel coding unit for performing a channel coding with respect to at least one bit array being input into the channel coding unit in order to output at least one systematic bit array and a plurality of parity bit arrays, the transmitter comprising:

    at least one bit interleaver for receiving the parity bit arrays and performing bit interleaving with respect to the parity bit arrays in such a manner that a repetition period of parity bits in each parity bit array does not match with a puncturing pattern for a rate matching; and
    a rate matching unit for receiving at least one systematic bit array and the parity bit arrays, which have undergone the bit interleaving, in order to perform the rate matching with respect to at least one systematic bit array and the parity bit arrays, wherein a number of bits forming the systematic bit array and the parity bit arrays output through the rate matching is identical to a number of bits to be transmitted through at least one assigned physical channel.

2. The transmitter as claimed in claim 1, wherein the bit interleaver performs the bit interleaving with respect to each parity bit array.

3. The transmitter as claimed in claim 1, wherein the bit interleaver performs the bit interleaving with respect to the parity bit arrays such that the bit interleaving is realized between parity bit arrays.

4. A method of receiving data in a mobile communication system including a channel coding unit for performing a channel coding with respect to at least one bit array being input into the channel coding unit in order to output at least one systematic bit array and a plurality of parity bit arrays, the method comprising the steps of:

i) receiving the parity bit arrays and performing bit interleaving with respect to the parity bit arrays in such a manner that a repetition period of parity bits in each parity bit array does not match with a puncturing pattern for a rate matching; and
ii) receiving at least one systematic bit array and the parity bit arrays, which have undergone the bit interleaving, in order to perform the rate matching with respect to at least one systematic bit array and the parity bit arrays, wherein a number of bits forming the systematic bit array and the parity bit arrays output through the rate matching is identical to a number of bits to be transmitted through at least one assigned physical channel.

5. The method as claimed in claim 4, wherein the bit interleaving is performed with respect to each parity bit array.

6. The method as claimed in claim 4, wherein the bit interleaving is performed with respect to the parity bit arrays such that the bit interleaving is realized between parity bit arrays.

7. A transmitter for a mobile communication system including a channel coding unit for performing channel coding with respect to at least one bit array being input into the channel coding unit in order to output at least one systematic bit array and a plurality of parity bit arrays, the transmitter comprising:

at least one bit interleaver receiving the parity bit arrays and performing bit interleaving with respect to the parity bit arrays in such a manner that a repetition period of parity bits in each parity bit array does not match with a puncturing pattern for a rate matching;
a rate matching unit receiving at least one systematic bit array and first parity bit arrays or second parity bit arrays, which have undergone the bit interleaving, in order to perform the rate matching with respect to at least one systematic bit array and the first parity bit arrays or the second parity bit arrays in such a manner that a predetermined number of bits to be transmitted through at least one assigned physical channel is output from the rate matching unit; and
a switch unit for switching the parity bit arrays to at least one bit interleaver when a specific coding rate is used for channel coding and switching the parity bit arrays to the rate matching unit when coding rates different from the specific coding rate are used for the channel coding, wherein parity bit arrays having a repetition period matching a puncturing pattern for the rate matching are output at the specific coding rate.

8. The transmitter as claimed in claim 7, further comprising:

a control unit for controlling the switch unit according to the coding rate used for the channel coding.

9. The transmitter as claimed in claim 7, wherein the bit interleaver performs the bit interleaving with respect to each parity bit array.

10. The transmitter as claimed in claim 7, wherein the bit interleaver performs the bit interleaving with respect to the parity bit arrays such that the bit interleaving is realized between parity bit arrays.

11. A method of transmitting data in a mobile communication system including a channel coding unit for performing a channel coding with respect to at least one bit array being input into the channel coding unit in order to output at least one systematic bit array and a plurality of parity bit arrays, the method comprising the steps of:

i) receiving the parity bit arrays when a specific coding rate is used for a channel coding and performing bit interleaving with respect to the parity bit arrays in such a manner that a repetition period of parity bits in each parity bit array does not match with a puncturing pattern for rate matching;
ii) receiving at least one systematic bit array and parity bit arrays, which have undergone the bit interleaving, in order to perform the rate matching with respect to at least one systematic bit array and the parity bit arrays in such a manner that a predetermined number of bits to be transmitted through at least one assigned physical channel is output; and
iii) receiving at least one systematic bit array and parity bit arrays when coding rates different from the specific coding rate are used for the channel coding in order to perform the rate matching with respect to at least one systematic bit array and the parity bit arrays in such a manner that a predetermined number of bits to be transmitted through at least one assigned physical channel is output, wherein parity bit arrays having a repetition period matching a puncturing pattern for the rate matching are output at the specific coding rate.

12. The method as claimed in claim 11, wherein the bit interleaving is performed with respect to each parity bit array.

13. The method as claimed in claim 11, wherein the bit interleaving is performed with respect to the parity bit arrays such that the bit interleaving is realized between parity bit arrays.

14. A transmitter for a mobile communication system, the transmitter comprising:

a channel coding unit for performing channel coding with respect to at least one bit array according to a predetermined coding rate in order to output coded bit arrays:

a bit selection unit for selecting at least one systematic bit array and a plurality of parity bit arrays from the coded bit arrays;
a control unit for outputting a switch control signal depending on a coding rate being used;
a switch unit for switching the parity bit arrays based on the switch control signal;
at least one bit interleaver for receiving the parity bit arrays from the switch section when a specific coding rate is used as the predetermined coding rate and performing bit interleaving with respect to the parity bit arrays in such a manner that a repetition period of parity bits in each parity bit array does not match a puncturing pattern for a rate matching; and
a rate matching unit receiving first parity bit arrays, which have undergone the bit interleaving or second parity bit arrays transmitted from the switch unit when coding rates different from the specific coding rate are used together with at least one systematic bit array in order to perform the rate matching with respect to at least one systematic bit array and the first parity bit arrays or the second parity bit arrays in such a manner that a predetermined number of bits to be transmitted through at least one assigned physical channel is output from the rate matching unit, wherein parity bit arrays having a repetition period matching with a puncturing pattern for the rate matching arc output at the specific coding rate.

15. The transmitter as claimed in claim 14, wherein the bit interleaver performs the bit interleaving with respect to each parity bit array.

16. The transmitter as claimed in claim 14, wherein the bit interleaver performs the bit interleaving with respect to the parity bit arrays such that the bit interleaving is realized between parity bit arrays.

17. A method of transmitting data in a mobile communication system, the method comprising the steps of:

i) performing a channel coding with respect to at least one bit array according to a predetermined coding rate in order to output coded bit arrays:
ii) selecting at least one systematic bit array and a plurality of parity bit arrays from the coded bit arrays;
iii) receiving the parity bit arrays when a specific coding rate is used as the predetermined coding rate and performing bit interleaving with respect to the parity bit arrays in such a manner that a repetition period of parity bits in each parity bit array does not match with a puncturing pattern for a rate matching;
iv) receiving the parity bit arrays, which have undergone the bit interleaving, and at least one systematic bit array in order to perform the rate matching with respect to the parity bit arrays and at least one systematic bit array in such a manner that a predetermined number of bits to be transmitted through at least one assigned physical channel is output; and
v) receiving the parity bit arrays and at least one systematic bit array when coding rates different from the specific coding rate are used as the predetermined coding rate and performing the rate matching with respect to the parity bit arrays and at least one systematic bit array in such a manner that a predetermined number of bits to be transmitted through at least one assigned physical channel is output, wherein parity bit arrays having a repetition period matching a puncturing pattern for the rate matching are output at the specific coding rate.

18. The method as claimed in claim 17, wherein the bit interleaving is performed with respect to each parity bit array.

19. The method as claimed in claim 17, wherein the bit interleaving is performed with respect to the parity bit arrays such that the bit interleaving is realized between parity bit arrays.

20. A receiver for receiving coded bit arrays including at least one systematic bit array and a plurality of parity bit arrays in a mobile communication system, the receiver comprising:

a de-rate matching unit for receiving the parity bit arrays and at least one systematic bit array in order to perform a de-rate matching with respect to the parity bit arrays and at least one systematic bit array; and

at least one bit de-interleaver for receiving the parity bit arrays, which have undergone the de-rate matching, and performing a bit de-interleaving with respect to the parity bit arrays in such a manner that parity bits in each parity bit array have a repetition period identical to a repetition period of parity bits which do not undergo the bit interleaving in the transmitter.

21. The receiver as claimed in claim 20, wherein the bit de-interleaver performs the bit de-interleaving with respect to each parity bit array.

22. The receiver as claimed in claim 20, wherein the bit de-interleaver performs the bit de-interleaving with respect to the parity bit arrays such that the bit de-interleaving is realized between parity bit arrays.

23. A method for receiving coded bit arrays including at least one systematic bit array and a plurality of parity bit arrays in a mobile communication system, the method comprising the steps of:

i) receiving the parity bit arrays and at least one systematic bit array in order to perform a de-rate matching with respect to the parity bit arrays and at least one systematic bit array; and

ii) receiving the parity bit arrays, which have undergone the de-rate matching, and performing a bit de-interleaving with respect to the parity bit arrays in such a manner that parity bits in each parity bit array have a repetition period identical to a repetition period of parity bits which do not undergo the bit interleaving in a transmitter.

24. The method as claimed in claim 23, wherein the bit de-interleaving is performed with respect to each parity bit array.

25. The method as claimed in claim 23, wherein the bit de-interleaving is perfonned with respect to the parity bit arrays such that the bit de-interleaving is realized between parity bit arrays.

26. A receiver for receiving coded bit arrays including at least one systematic bit array and a plurality of parity bit arrays in a mobile communication system, the receiver comprising:

a de-rate matching unit for receiving the parity bit arrays and at least one systematic bit array in order to perform a de-rate matching with respect to the parity bit arrays and at least one systematic bit array;

at least one bit de-interleaver for receiving the parity bit arrays, which have undergone the de-rate matching, and performing a bit de-interleaving with respect to the parity bit arrays in such a manner that parity bits in each parity bit array have a repetition period identical to a repetition period of parity bits which do not undergo the bit interleaving in a transmitter;

a bit collection unit for receiving at least one bit array and first parity bit arrays or second parity bit arrays, which have undergone the bit de-interleaving, in order to output one coded bit array; and

a switch unit for switching the parity bit arrays to at least one bit de-interleaver when a specific coding rate is used for a channel coding and switching the parity bit arrays to the bit collection unit when coding rates different from the specific coding rate are used for the channel coding, wherein parity bit arrays having a repetition period matching a puncturing pattern for the rate matching are output at the specific coding rate.

27. The receiver as claimed in claim 26, further comprising a control unit for controlling the switch unit according to the coding rate used for the channel coding.

28. The receiver as claimed in claim 26, wherein the bit de-interleaver performs the bit de-interleaving with respect to each parity bit array.

29. The receiver as claimed in claim 26, wherein the bit de-interleaver performs the bit de-interleaving with respect to the parity bit arrays such that the bit de-interleaving is realized between parity bit arrays.

30. A method for receiving coded bit arrays including at least one systematic bit array and a plurality of parity bit arrays in a mobile communication system, the method comprising the steps of

i) receiving the parity bit arrays and at least one systematic bit array in order to perform a de-rate matching with respect to the parity bit arrays and at least one systematic bit array;

ii) performing bit de-interleaving with respect to the parity bit arrays when a specific coding rate is used for a channel coding in such a manner that parity bits in each parity bit array have a repetition period identical to a repetition period of parity bits which do not undergo the bit interleaving in a transmitter;

iii) receiving at least one bit array and the parity bit arrays, which have undergone the bit de-interleaving, in order to output one coded bit array; and

iv) receiving at least one bit array and the parity bit arrays in order to output one coded bit array when coding rates different from the specific coding rate are used for the channel coding, wherein parity bit arrays having a repetition period matching a puncturing pattern for the rate matching are output at the specific coding rate.

31. The method as claimed in claim 23, wherein the bit de-interleaving is performed with respect to each parity bit array.

32. The method as claimed in claim 23, wherein the bit de-interleaving is performed with respect to the parity bit arrays such that the bit de-interleaving is realized between parity bit arrays.

Input ———————————————————————→ X

110

1ST ENCODER ————→ Y

100                120

INTERNAL
INTERLEAVER ——→ 2ND ENCODER ————→ Z

# FIG.1

EP 1 511 209 A2

Input Bit → **210** TAIL BIT INSERTION UNIT → **212** CHANNEL CODING UNIT → **214** SYMBOL REPETITION UNIT → **216** SYMBOL PUNCTURING UNIT → **218** BLOCK INTERLEAVER →

# FIG.2

TRANSPORT BLOCK

↓

| CRC attachment | ~301 |

↓

| Code block segmentation | ~303 |

↓

| Channel Coding | ~305 |

↓

| Physical Layer Hybrid-ARQ functionality | ~307 |

↓

| Physical channel segmentation | ~309 |

↓ ... ↓

| HS-DSCH Interleaving | ~311 |

↓ ... ↓

| Physical channel mapping | ~313 |

↓ ... ↓

| Bit re-arrangement for 16 QAM | ~315 |

↓ ... ↓

PhCH#1     PhCH#N

# FIG.3

FIG.4

EP 1 511 209 A2

PAS no HARQ

FIG.5

FIG.6

FIG.7

820

HARQ Functionality

810

822

824

| CHANNEL<br>CODING UNIT | → | BIT<br>INTERLEAVER | → | RATE<br>MATCHING UNIT | → |

FIG.8

FIG.9

TRANSPORT BLOCK

↓

| CRC attachment | ~1001 |

↓

| Bit Scrambling | ~1003 |

↓

| Code block segmentation | ~1005 |

↓

| Channel Coding | ~1007 |

↓

| Bit Interleaving | ~1009 |

↓

| Physical Layer Hybrid-ARQ functionality | ~1011 |

↓

| Physical channel segmentation | ~1013 |

...

| HS-DSCH Interleaving | ~1015 |

...

| Bit re-arrangement for 16 QAM | ~1017 |

...

| Physical channel mapping | ~1019 |

...

PhCH#1          PhCH#N

# FIG.10

FIG.11

EP 1 511 209 A2

1202

Bit Interleaver

1212

• • •

encoded data →

BIT SELECTION UNIT

First parity bits

1204

1208

1ST BIT INTERLEAVER

1ST RATE MATCHING UNIT

Second parity bits

1206

1210

2ND BIT INTERLEAVER

PARAMETERS FOR EFFECTIVE CODING RATE →

EFFECTIVE CODING RATE DETECTION UNIT

1216

CONTROL UNIT

1214

MEMORY

1218

FIG.12

FIG.13

EP 1 511 209 A2

1402

Bit Interleaver

1408

encoded data →

BIT
SELECTION
UNIT

. . .

1404

First parity bits →

1ST BIT
INTERLEAVER

1ST RATE
MATCHING
UNIT

1406

Second parity bits →

2ND BIT
INTERLEAVER

FIG.14

FIG.15

SET SPECIFIC CODING RATE ~1602

1604

IS PRESENT CODING RATE IDENTICAL TO SPECIFIC CODING RATE?

NO

YES

BIT INTERLEAVING ~1606

RATE MATCHING ~1608

# FIG.16

BIT SELECTION ~1702

BIT INTERLEAVING ~1704

RATE MATCHING ~1706

# FIG.17

1810

HARQ Functionality

1812

DE-RATE
MATCHING UNIT

1814

BIT
DE-INTERLEAVER

1820

CHANNEL
DECODING UNIT

FIG.18

PhCH#1      PhCH#N

...

Physical channel
De-mapping                    ~1901

...

Bit De-Rearrangement
for 16 QAM                    ~1903

...

HS-DSCH
De-Interleaving               ~1905

...

Physical  channel
De-segmentation               ~1907

Bit De-Interleaving           ~1909

Channel De-Coding             ~1911

Code block
De-segmentation               ~1913

Bit De-Scrambling             ~1915

CRC De-attachment             ~1917

TRANSPORT BLOCK

FIG.19

EP 1 511 209 A2

FIG.20

FIG.21

EP 1 511 209 A2

PEFORM DE-RATE MATCHING — 2201

IS PRESENT CODING RATE IDENTICAL TO SPECIFIC CODING RATE? — 2203

NO

YES

BIT DE-INTERLEAVING — 2205

BIT COLLECTING — 2207

# FIG.22

PERFORM DE-RATE MATCHING — 2302

BIT DE-INTERLEAVING — 2304

BIT COLLECTING — 2306

# FIG.23

FIG.24

EP 1 511 209 A2

FIG.25

EP 1 511 209 A2

Input
Bit → | FRAME QUALITY IDENTIFIER INSERTION UNIT (2601) | → | TAIL BIT INSERTION UNIT (2603) | → | CHANNEL CODING UNIT (2605) | → | INTERLEAVER (2607) | → | SYMBOL REPETITION UNIT (2609) | → | SYMBOL PUNCTURING UNIT (2611) | →

## FIG.26

TRANSPORT BLOCK

CRC attachment — 2701

Bit Scrambling — 2703

Code block segmentation — 2705

Channel Coding — 2707

HS-DSCH Bit Interleaving — 2709

Physical Layer Hybrid-ARQ functionality — 2711

Physical channel segmentation — 2713

...

Bit re-arrangement for 16 QAM — 2715

...

Physical channel mapping — 2717

...

PhCH#1     PhCH#N

FIG.27

FIG.28

Critical Ior/Ioc vs. Code Rate

FIG.29

EP 1 511 209 A2

Critical Ior/Ioc vs. Code Rate

FIG.30